# EUROPEAN PATENT APPLICATION

(11) **EP 3 358 333 A1**
(43) Date of publication of application: **08.08.2018**
(21) Application number: 16851243.2
(22) Date of filing: 16.09.2016
(51) Int. Cl.: G01M 99/00, G05B 23/02

(54) **FAULT INDICATION AND DIAGNOSING DEVICE**

(30) Priority: 01.10.2015 JP 2015196071; 12.08.2016 JP 2016158898
(71) Applicant: DENSO CORPORATION, Kariya-city, Aichi 448-8661 (JP)
(72) Inventor: HARADA, Toshikazu, Kariya-city Aichi 448-8661 (JP); SAKAIDA, Atusi, Kariya-city Aichi 448-8661 (JP); TANIGUCHI, Toshihisa, Kariya-city Aichi 448-8661 (JP); GOUKO, Norio, Kariya-city Aichi 448-8661 (JP); SHIRAISHI, Yoshihiko, Kariya-city Aichi 448-8661 (JP); TANAKA, Yasuhiro, Kariya-city Aichi 448-8661 (JP); SAITOU, Keita, Kariya-city Aichi 448-8661 (JP); MATSUI, Hirohito, Nishio-city Aichi 445-0012 (JP)
(74) Representative: Kuhnen & Wacker Patent- und Rechtsanwaltsbüro PartG mbB
(86) International application number: PCT/JP2016/077491
(87) International publication number: WO 2017/057069

(57) **Abstract**

An abnormality diagnostic apparatus 1 includes: a heat flux sensor 10 that detects heat flux generated by a measurement target continuously from the start of operation of the measurement target or at predetermined time intervals; and a control device 12 that determines whether there is an abnormality based on the result of the detection by the heat flux sensor 10. In the event of an abnormality in a facility, heat flux generated from the facility by at least one of current, voltage, sound, vibration, and friction changes. Therefore, the use of the heat flux sensor 10 makes it possible to determine the presence or absence of an abnormality in the measurement target without using a plurality of kinds of sensors to measure current, voltage, sound, vibration, and friction.

## Description

### [Technical Field]

The present invention relates to an abnormality diagnostic apparatus.

### [Background Art]

For example, PTL 1 discloses a heat flux sensor that detects heat flux.

### [Citation List]

### [Patent Literature]

[PTL 1] Japanese Patent No. 5376086

### [Summary of the Invention]

### [Technical Problem]

Facility maintenance includes preventive maintenance such as repair, replacement, and updating before occurrence of accidents such as failure or breakage. The facility here includes apparatuses, devices, systems, and others. As the preventive maintenance, time-based maintenance is performed in general. That is, maintenance work such as replacement or repair is carried out within a specific period. This period is set based on endurance test data and the deterioration state of real equipment used for many years. In addition, the period is set to be shorter than the lifetime of the actual facility allowing for a safety factor.

In many cases, however, the period set based on the endurance test data acquired by a facility may be different from the real one, even if they are of the same model, and the deterioration state of the real equipment used for many years does not become equal to the lifetime of the actual facility. This is why maintenance is performed within a period shorter than the lifetime allowing for the safety factor. At the maintenance, some components in the normal state may be replaced and discarded. In addition, even though the period is set to be shorter than the lifetime allowing for the safety factor, some components may become failed earlier than the end of the period. This may cause severe damage such as the breakage of other components. Therefore, the time-based maintenance of the facility may not necessarily be performed at an appropriate time.

As preventive maintenance for solving this problem, there is condition-based maintenance by which the condition of a facility is monitored and the maintenance of the facility is performed when an abnormality is detected before occurrence of an actual failure. The abnormality is a sign of failure or malfunction. The abnormality appears as fluctuations in current, voltage, sound (that is, air vibration), object vibration, or the like. According to the condition-based maintenance, maintenance work can be performed at an appropriate period.

In conventional cases, however, a dedicated sensor is necessary in correspondence with an abnormality to be detected. For example, a voltage sensor is necessary to detect fluctuations in voltage, and a vibration sensor is necessary to detect fluctuations in object vibration. Accordingly, it is necessary to select the sensor to be used according to the abnormality to be detected. In addition, when there is a plurality of kinds of abnormalitys to be detected, a plurality of types of sensors needs to be used.

In light of the foregoing circumstances, an object of the present invention is to provide an abnormality diagnostic apparatus that can determine the presence or absence of an abnormality in a measurement target using one type of sensor regardless of the kind of an abnormality to be detected.

### [Solution to Problem]

To attain the foregoing object, one mode disclosed herein is an abnormality diagnostic apparatus that determines the presence or absence of an abnormality that appears before occurrence of a failure in a measurement target, including: a heat flux sensor that detects heat flux generated by a measurement target continuously from the start of operation of the measurement target or at predetermined time intervals; and a determination unit that determines whether there is an abnormality based on the result of the detection by the heat flux sensor.

All or some components of the facility generate heat flux by at least one of current, voltage, sound, vibration, and friction. The inventor of the present invention has revealed that the heat flux generated by the facility varies depending on an abnormality in the facility.

Accordingly, the abnormality diagnostic apparatus detects the heat flux generated by the measurement target continuously or in a predetermined cycle. Based on the result of the detection, the abnormality diagnostic apparatus determines whether there is an abnormality. This makes it possible to determine the presence or absence of an abnormality in the measurement target using one type of sensor regardless of the kind of the abnormality to be detected.

The parenthesized reference signs given to the units described in the claims are examples of correspondences with the specific units in the embodiments described later.

### [Brief Description of the Drawings]

Fig. 1 is a diagram illustrating an abnormality diagnostic apparatus and a battery according to a first embodiment;
Fig. 2 is a planar view of a heat flux sensor illustrated in Fig. 1;
Fig. 3 is a cross-sectional view of Fig. 2 taken along line III-III;
Fig. 4 is a diagram illustrating an equivalent circuit of a battery illustrated in Fig. 1;
Fig. 5 is a flowchart of a diagnostic control of preventive maintenance in the first embodiment;
Fig. 6 is a diagram illustrating temporal changes in heat flux with the battery in the normal state;
Fig. 7 is a diagram illustrating temporal changes in heat flux with the battery in the deteriorated state;
Fig. 8 is a diagram illustrating temporal changes in heat flux with the battery in the failed state;
Fig. 9 is a diagram illustrating an abnormality diagnostic apparatus and a drilling machine according to a second embodiment;
Fig. 10 is a flowchart of a diagnostic control of preventive maintenance according to the second embodiment;
Fig. 11 is a diagram illustrating temporal changes in heat flux with a drill blade in the normal state;
Fig. 12 is a diagram illustrating temporal changes in heat flux with the drill blade in the deteriorated state;
Fig. 13 is a diagram illustrating temporal changes in heat flux with the drill blade in the failed state;
Fig. 14 is a diagram illustrating an abnormality diagnostic apparatus and a fan filter unit according to a third embodiment;
Fig. 15 is a diagram illustrating temporal changes in heat flux with a filter in the deteriorated state;
Fig. 16 is a diagram illustrating temporal changes in heat flux with the filter in the deteriorated state;
Fig. 17 is a diagram illustrating temporal changes in heat flux with the filter in the failed state;
Fig. 18 is a diagram illustrating an abnormality diagnostic apparatus and an automatic door device according to a fourth embodiment;
Fig. 19 is a flowchart of a diagnostic control of preventive maintenance according to the fourth embodiment;
Fig. 20 is a diagram illustrating temporal changes in heat flux with the automatic door device in the normal state;
Fig. 21 is a diagram illustrating temporal changes in heat flux with the automatic door device in the deteriorated state;
Fig. 22 is a diagram illustrating temporal changes in heat flux with the automatic door device in the failed state;
Fig. 23 is a diagram illustrating an abnormality diagnostic apparatus and a tensioner in a belt conveyor according to a fifth embodiment;
Fig. 24 is a side view of the belt conveyor;
Fig. 25 is an enlarged view of a drive unit illustrated in Fig. 24;
Fig. 26 is a diagram illustrating temporal changes in heat flux with a conveyor belt illustrated in Fig. 24 in the normal state;
Fig. 27 is a side view of the drive unit, which illustrates the state of the drive belt illustrated in Fig. 26 at a first period;
Fig. 28 is a side view of the tensioner illustrated in Fig. 26, which illustrates a first state at the first period;
Fig. 29 is a side view of the tensioner illustrated in Fig. 26, which illustrates a second state at the first period;
Fig. 30 is a diagram illustrating temporal changes in heat flux with the conveyor belt in the normal state, the deteriorated state, and the failed sate;
Fig. 31 is a flowchart of a diagnostic control of preventive maintenance according to the fifth embodiment;
Fig. 32 is a diagram illustrating an abnormality diagnostic apparatus and a stopper in a belt conveyor according to a sixth embodiment;
Fig. 33 is a schematic diagram illustrating a state of deformation of the stopper illustrated in Fig. 32;
Fig. 34 is a diagram illustrating temporal changes in heat flux with an elastic body illustrated in Fig. 32 in the normal state, the deteriorated state, and the failed state;
Fig. 35 is a diagram illustrating an abnormality diagnostic apparatus and an air cylinder according to a seventh embodiment;
Fig. 36A is a cross-sectional view of the air cylinder illustrated in Fig. 35 in a period P21;
Fig. 36B is a cross-sectional view of the air cylinder illustrated in Fig. 35 in a period P22;
Fig. 36C is a cross-sectional view of the air cylinder illustrated in Fig. 35 in a period P23;
Fig. 36D is a cross-sectional view of the air cylinder illustrated in Fig. 35 in a period P23;
Fig. 37 is a diagram illustrating temporal changes in heat flux with a seal member illustrated in Fig. 35 in the normal state;
Fig. 38 is a diagram illustrating temporal changes in heat flux with the seal member illustrated in Fig. 35 in the normal state, the deteriorated state, and the failed sate;
Fig. 39 is a diagram illustrating an abnormality diagnostic apparatus and part of a chuck device according to an eighth embodiment;
Fig. 40 is a front view of the chuck device according to the eighth embodiment;
Fig. 41 is a diagram illustrating temporal changes in heat flux with an elastic body illustrated in Fig. 39 in the normal state, the deteriorated state, and the failed sate;
Fig. 42 is a diagram illustrating an abnormality diagnostic apparatus and a shock absorber according to a ninth embodiment; and
Fig. 43 is a diagram illustrating temporal changes in heat flux with a seal member illustrated in Fig. 42 in the normal state, the deteriorated state, and the failed state.

### [Description of Embodiments]

Embodiments of the present invention will be described with reference to the drawings. The identical or equivalent components in the following embodiments will be described with the same reference signs.

### (First embodiment)

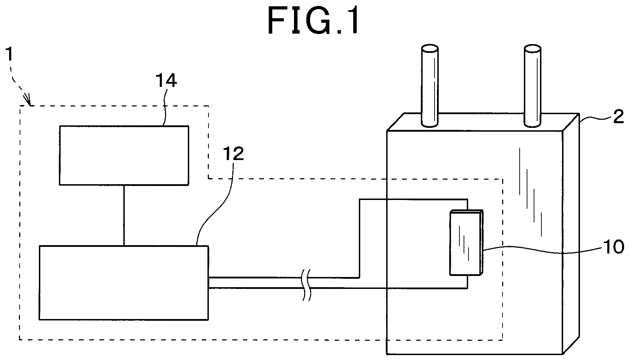

An abnormality diagnostic apparatus 1 of a first embodiment illustrated in Fig. 1 (hereinafter, simply called diagnostic apparatus 1) is designed to make a preventive maintenance diagnosis of a battery 2 as a measurement target. The battery 2 is a lithium battery cell.

The diagnostic apparatus 1 includes a heat flux sensor 10, a control device 12, and a display device 14.

The heat flux sensor 10 is designed to detect the heat flux generated by the battery 2. The heat flux sensor 10 is installed on the surface of the battery 2. The heat flux sensor 10 is flat plate-like in shape. The internal structure of the heat flux sensor 10 will be described later. The heat flux sensor 10 outputs a sensor signal according to the heat flux traveling from the inside to outside of the battery 2.

The control device 12 is designed to perform a diagnostic control of preventive maintenance of the battery 2. The diagnostic control is performed to determine the presence or absence of an abnormality based on the heat flux detected by the heat flux sensor 10. The abnormality means a sign of failure or malfunction. The abnormality appears in a facility in the deteriorated state before occurrence of failure or malfunction. The heat flux sensor 10 is connected to an input side of the control device 12. The heat flux sensor 10 constantly inputs a sensor signal into the control device 12. According to the first embodiment, the control device 12 is a determination unit that determines whether there is an abnormality based on the result of the detection by the heat flux sensor 10.

The display device 14 is connected to an output side of the control device 12. In the event of an abnormality or a failure, the control device 12 causes the display device 14 to display a notification of the abnormality or failure. The control device 12 has a microcomputer, a storage unit, and the like.

The display device 14 is a notification device that notifies the user of an abnormality or the like. The display device 14 may be a liquid crystal display or the like.

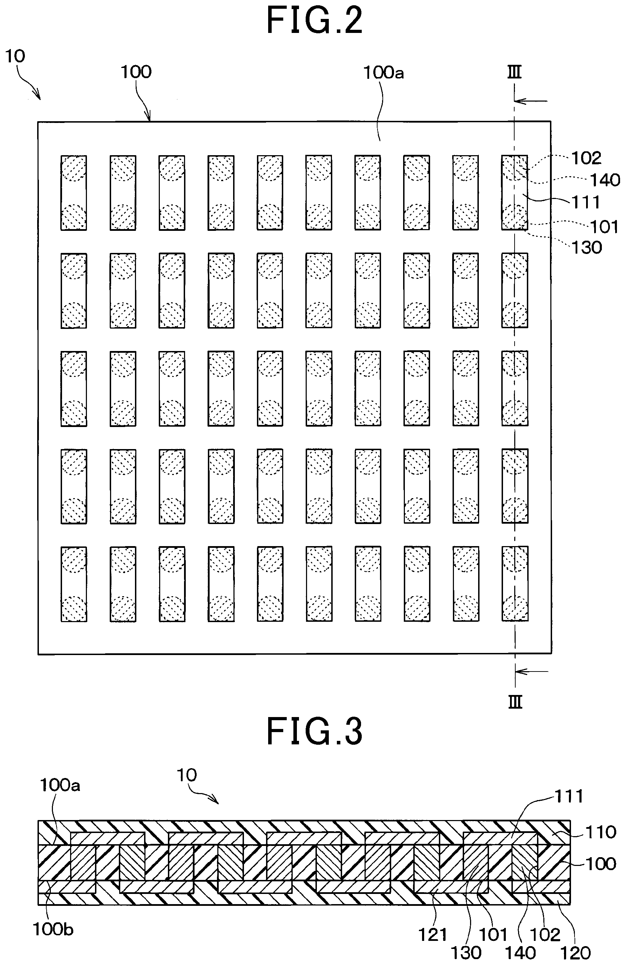

Next, the heat flux sensor 10 will be described. As illustrated in Figs. 2 and 3, the heat flux sensor 10 is structured in such a manner that an insulation base material 100, a front surface protection member 110, and a back surface protection member 120 are integrated and first and second interlayer connection members 130 and 140 are alternately connected in series inside the integrated component. Fig. 2 does not illustrate the front surface protection member 110. The insulation base material 100, the front surface protection member 110, and the back surface protection member 120 are film-like in shape and formed from a flexible resin material such as a thermoplastic resin. The insulation base material 100 has pluralities of first and second via holes 101 and 102 penetrating in the thickness direction. The first and second via holes are filled with the first and second interlayer connection members 130 and 140 made from different metals or thermoelectric materials such as semiconductors. A front surface conductor pattern 111 is disposed on a front surface 100a of the insulation base material 100 to form first connection portions for the first and second interlayer connection members 130 and 140. A back surface conductor pattern 121 is disposed on a back surface 100b of the insulation base material 100 to form second connection portions for the first and second interlayer connection members 130 and 140.

When a heat flux passes through the heat flux sensor 10 in the thickness direction, there arises a temperature difference between the first connection portions and the second connection portions for the first and second interlayer connection members 130 and 140. This generates thermoelectric power between the first and second interlayer connection members 130 and 140 by the Seebeck effect. The heat flux sensor 10 outputs the thermoelectric power (for example, voltage) as a sensor signal.

Next, the diagnostic control of preventive maintenance performed by the control device 12 of the first embodiment will be described.

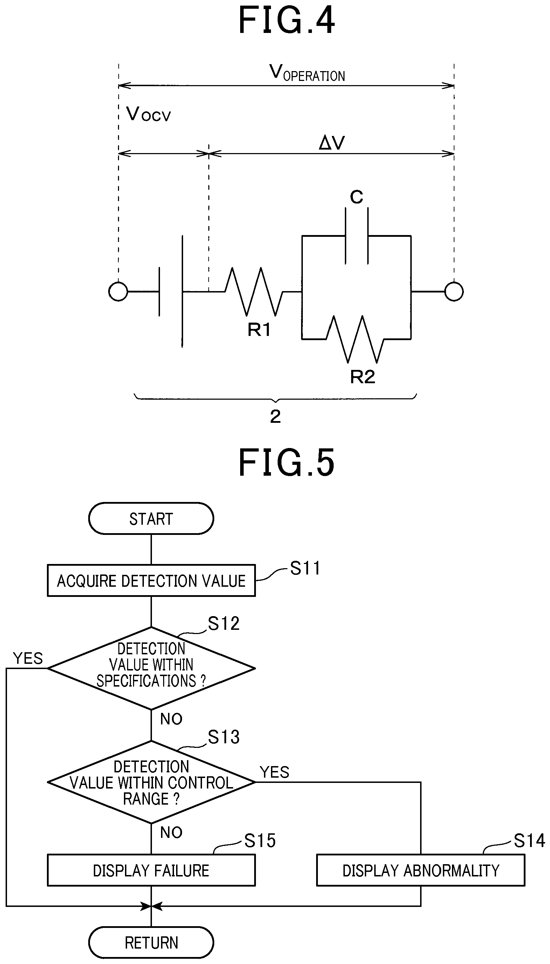

As illustrated in Fig. 4, first, the battery 2 has internal resistances R1 and R2. Referring to Fig. 4, reference sign Vocv represents open voltage, ΔV represents voltage drop due to the internal resistances R1 and R2, V operation represents actual voltage in the battery 2. The battery 2 generates heat by the voltage applied to the internal resistances R1 and R2 and the current flowing through the internal resistances R1 and R2. This produces heat flux traveling from the inside to outside of the battery 2. When the battery 2 becomes deteriorated, the internal resistances R1 and R2 increase and the voltage drop ΔV becomes greater. Accordingly, the amount of heat generation becomes larger and the heat flux increases as compared to a case with the battery 2 in the normal state.

The heat flux sensor 10 constantly measures the heat flux from the battery 2. The control device 12 determines the presence or absence of an abnormality based on the measured heat flux as described in the flowchart of Fig. 5. The steps described in Fig. 5 constitute functional units for implementing various functions. The same applies to flowcharts described in the other drawings. The process described in Fig. 5 is carried out from the start to stop of operation of the battery 2. The start and stop of operation of the battery 2 are determined by, for example, the start and stop of operation of an electric device connected to the battery 2.

As described in Fig. 5, at step S11, the detection value of the heat flux sensor 10 is acquired. The detection value is a calculation value obtained by calculating the value of the heat flux from the value of the voltage input from the heat flux sensor 10. Alternatively, the detection value may be the value of the voltage input from the heat flux sensor 10.

At step S12, it is determined whether the detection value falls within specifications. The specifications have predetermined upper limit value and lower limit value. The specifications constitute a first reference range for determining whether the battery is in the normal state.

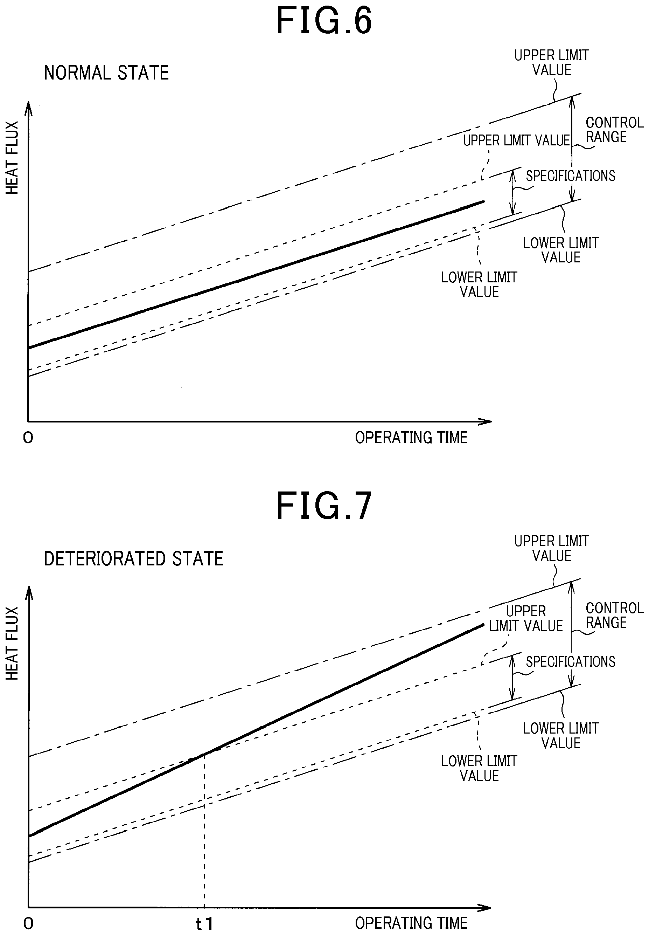

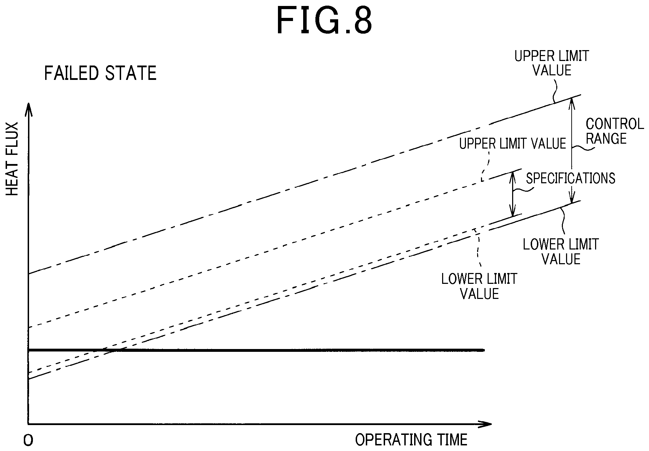

As described in Fig. 6, when the battery 2 is in the normal state, the heat flux increases at a predetermined ratio with increasing operating time. As illustrated in Fig. 7, when the battery 2 is in the deteriorated state, the amount of heat generation becomes larger than that with the battery 2 in the normal state. Accordingly, the increase rate of the heat flux to the operating time becomes higher. As illustrated in Fig. 8, when the battery 2 is in the failed state, there is no power distribution and the value of the heat flux becomes 0. Accordingly, as illustrated in Figs. 6 to 8, the specifications are set with an upper limit value and a lower limit value to discriminate the normal state from the other states of the battery 2. In other words, the specifications are set with an upper limit value and a lower limit value based on the change tendency of the heat flux generated by the battery 2 in the normal state during the period of time elapsed from the start of operation of the battery 2.

As illustrated in Fig. 6, when the battery 2 is in the normal state, the detection value falls within the specifications. Therefore, when the detection value falls within the specifications, a YES determination is made at step S12 and the process returns to step S11. When the detection value falls outside the specifications, a NO determination is made at step S12 and the process proceeds to step S13.

The determination at step S12 is made by comparing the detection value at the predetermined elapsed time to the specifications at the same elapsed time. Alternatively, the determination at step S12 may be made by comparing the waveform drawn by the detection values from the start of operation of the battery 2 to the predetermined elapsed time, to the line indicating the specifications until the same elapsed time as illustrated in Fig. 6. The same applies to the determination at step S13.

At step S13, it is determined whether the detection value falls within a control range. The control range is a second reference range for determining whether the battery 2 is in a deteriorated state. The control range is set with an upper limit value and a lower limit value to discriminate the deteriorated state from the failed state. The control range is set to include the specifications and be wider than the specifications. In the first embodiment, the lower limit value of the control range is almost equal to the lower limit value of the specifications. As illustrated in Fig. 7, with the battery 2 in the deteriorated state, when the time elapsed from the start of operation exceeds t1, the heat flux falls outside the specifications but falls within the control range. Therefore, when the detection value falls within the control range, a YES determination is made at step S13 and the process proceeds to step S14. At step S14, the display device 14 displays a notification of the abnormality. This allows maintenance personnel to take necessary measures such as recharging or replacement of the battery 2.

Meanwhile, when the battery 2 is in the failed state without power distribution, the detection value falls outside the control range. Therefore, when the detection value falls outside the control range, a NO determination is made at step S13 and the process proceeds to step S15. At step S15, the display device 14 displays a notification of the failure. This allows maintenance personnel to take necessary measures such as replacement of the battery 2.

In this way, the condition-based maintenance of the battery 2 is performed.

As described above, during operation of the battery 2, the heat flux is generated by the voltage applied to the internal resistances R1 and R2 and the current flowing through the internal resistances R1 and R2. When the battery 2 enters the deteriorated state, the internal resistances R1 and R2 increase as compared to those in the normal state. Accordingly, the voltage applied to the internal resistances R1 and R2 becomes higher and the heat flux generated by the battery 2 becomes greater.

In the diagnostic apparatus 1 of the first embodiment, the heat flux sensor 10 detects the heat flux generated by the battery 2 continuously from the start to end of operation of the battery 2. Then, it is determined whether there is an abnormality based on the result of the detection. This allows detection of an abnormality in the battery 2 without using a voltmeter or ammeter. Therefore, it is possible to learn the appropriate times for recharging and replacement of the battery 2.

In this way, the condition-based maintenance of the battery 2 can be carried out by using the diagnostic apparatus 1 of the first embodiment. The maintenance after the grasping of an abnormality causes no waste because the battery 2 can be used continuously until the end of its lifetime. In addition, even when the actual lifetime is shorter than the predicted one, the battery 2 can be recharged or replaced before the occurrence of a failure by grasping an abnormality. In general, the failure rate of a product draws a bath-tub curve with an initial failure, a stable period, and a deteriorated period. The maintenance of the battery 2 can be performed at an appropriate time because an abnormality can be grasped by the measurement of heat flux.

### (Second embodiment)

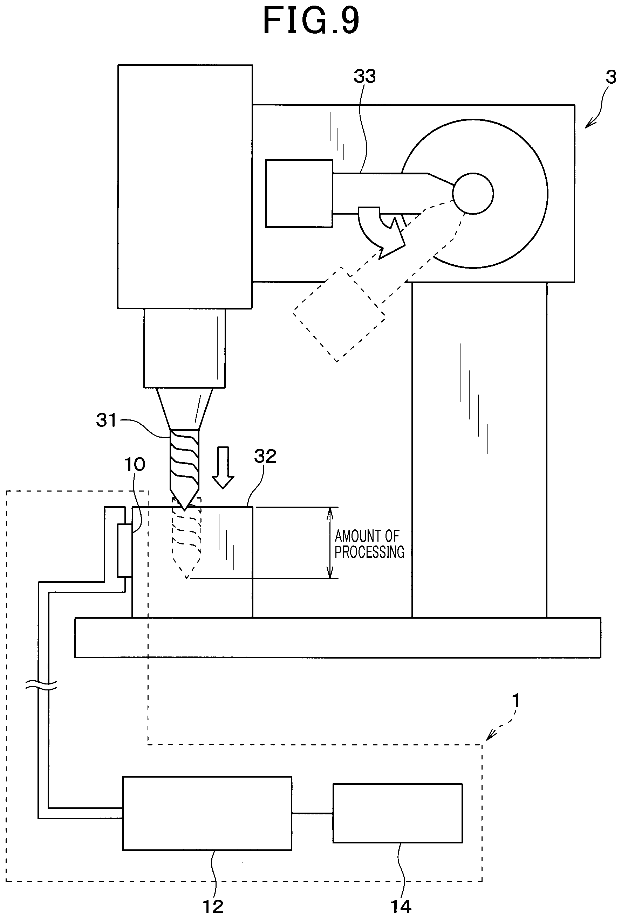

A diagnostic apparatus 1 of a second embodiment illustrated in Fig. 9 performs a preventive maintenance diagnosis of a drill 31 in a drilling machine 3 as a measurement target.

The drilling machine 3 is a processing device for drilling in a work piece. The drilling machine 3 includes the drill 31 spun by a motor not illustrated. The drill 31 is a cutting tool for use in cutting work. A work piece 32 is placed under the drill 31. The work piece 32 may be a metal block or the like. While the drill 31 is spun, the user operates a handle 33 downward. Accordingly, the spinning drill 31 moves downward while processing the work piece 32. In this way, the work piece 32 is drilled.

The diagnostic apparatus 1 is configured in the same manner as the first embodiment. A heat flux sensor 10 is installed on a side surface of the work piece 32.

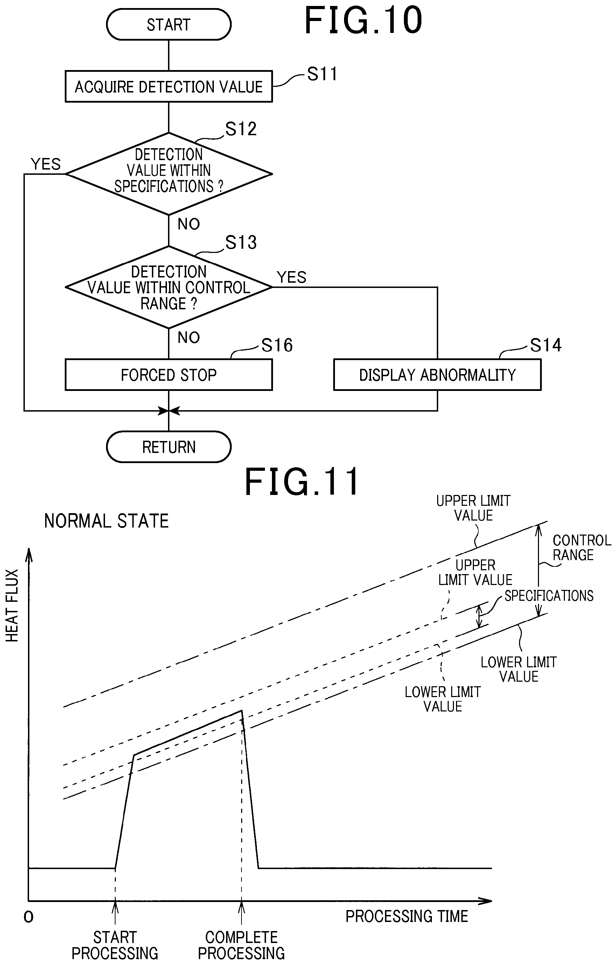

Next, the diagnostic control of preventive maintenance performed by a control device 12 of the second embodiment will be described. During the drilling work, the drill 31 generates heat flux due to the friction between the drill 31 and the work piece 32. Accordingly, the heat flux sensor 10 constantly measures the heat flux generated by the drill 31. The control device 12 determines the presence or absence of any abnormalities based on the measured heat flux as described in the flowchart of Fig. 10. The process described in Fig. 10 is carried out from the start to completion of the drilling work by the drill 31, that is, from the start to end of operation of the drill 31. For example, the control device 12 is configured to acquire information about an operational position of the handle 33. The start and completion of the drilling work are determined by the operational position of the handle 33.

At step S12, the detection value is compared to specifications to determine whether the detection value falls within the specifications. The specifications constitute a first reference range for determining whether a blade of the drill 31 is in the normal state.

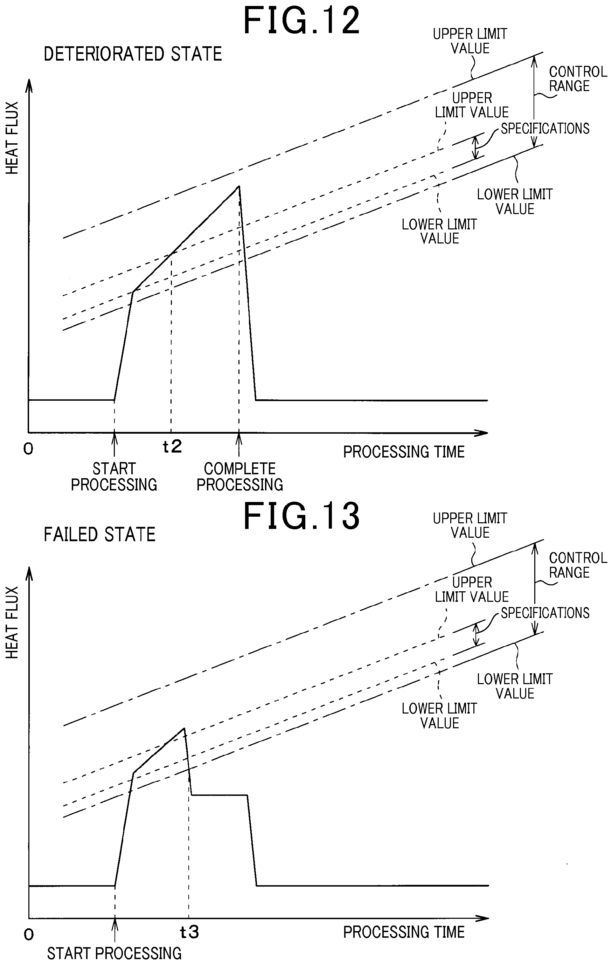

As illustrated in Fig. 11, when the blade of the drill 31 is in the normal state, the heat flux increases at a predetermined ratio with increasing processing time. As illustrated in Fig. 12, when the blade of the drill 31 is dull, that is, is in the deteriorated state, the frictional force becomes greater and the amount of heat generation increases as compared to those in the normal state. Accordingly, the increase ratio of heat flux to the processing time becomes higher. In addition, when the drilling work is continued with the dull blade of the drill 31, the blade gets damaged and enters the failed state. In this case, as illustrated in Fig. 13, the heat flux increases from the start of the processing to the damage of the blade, but after the damage of the blade, the heat flux decreases substantially. Therefore, the specifications are set with an upper limit value and a lower limit value to discriminate the normal state from the other states of the blade as illustrated in Figs. 11 to 13.

As illustrated in Fig. 11, when the blade is in the normal state, the detection value falls within the specifications. Therefore, when the detection value falls within the specifications, a YES determination is made at step S12 and the process returns to step S11. When the detection value falls outside the specifications, a NO determination is made at step S12 and the process proceeds to step S13.

At step S13, it is determined whether the detection value falls within a control range. The control range is a second reference range for determining whether the blade of the drill 31 is in the deteriorated state. The control range is set with an upper limit value and a lower limit value to discriminate the deteriorated state from the failed state of the drill 31.

As illustrated in Fig. 12, when the blade is in the deteriorated state, the detection value falls outside the specifications but falls within the control range from processing time t2 to the completion of the processing. Therefore, when the detection value falls within the control range, a YES determination is made at step S13 and the process proceeds to step S14. At step S14, the display device 14 displays a notification of the abnormality. This allows maintenance personnel to take necessary measures such as replacement of the drill 31.

Meanwhile, when the blade gets damaged and enters the failed state during processing, the detection value falls outside the control range as the processing time exceeds t3. Therefore, when the detection value falls outside the control range, a NO determination is made at step S13 and the process proceeds to step S16. At step S16, the spinning of the drill 31 is forcedly stopped. This allows maintenance personnel to replace the drill 31.

In this way, the condition-based maintenance of the drill 31 is performed.

As described above, according to the diagnostic apparatus 1 of the second embodiment, the use of the heat flux sensor 10 allows detection of an abnormality in the drill 31. Therefore, it is possible to learn the appropriate time for replacement of the drill 31. The diagnostic apparatus 1 of the second embodiment can perform the same preventive maintenance diagnosis as described above on cutting tools other than the drill 31.

### (Third embodiment)

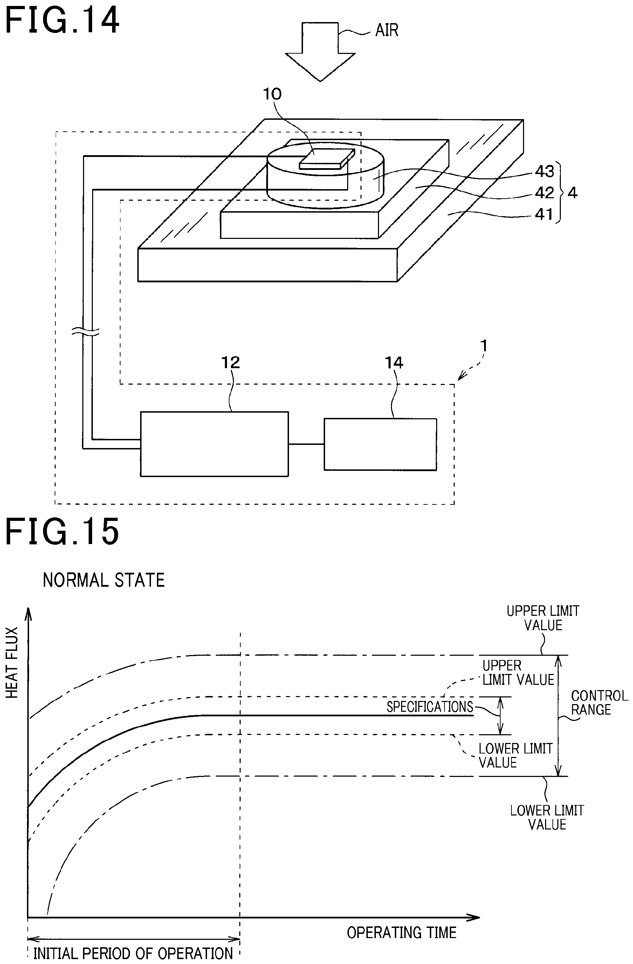

A diagnostic apparatus 1 of a third embodiment illustrated in Fig. 14 is designed to perform a preventive maintenance diagnosis of a fan filter unit 4 as a measurement target.

The fan filter unit 4 is designed to clean the air. The fan filter unit 4 includes a filter 41, a fan 42, and a motor 43. The filter 41 is a high efficiency particulate air (HEPA) filter, for example. The fan 42 is rotated by the motor 43 to form an air flow passing through the filter 41. When the air passes through the filter 41, the air is cleared of dirt and dust.

The diagnostic apparatus 1 is configured in the same manner as the first embodiment. A heat flux sensor 10 is installed on a surface of the motor 43.

Next, the diagnostic control of preventive maintenance performed by a control device 12 of the third embodiment will be described. The air makes a sound while passing through the filter 41. This sound, that is, the vibration of the air generates heat flux from the filter 41. The heat flux sensor 10 constantly measures the heat flux generated by the filter 41. As in the second embodiment, the control device 12 determines the presence or absence of an abnormality based on the measured heat flux as described in the flowchart of Fig. 10. The process described in Fig. 10 is carried out from the start to stop of operation of the fan 42.

In the third embodiment, at step S12 described in Fig. 10, it is determined whether the detection value falls within specifications. The specifications constitute a first reference range for determining whether the filter 41 is in the normal state.

As illustrated in Fig. 15, when the filter 41 is in the normal state, the heat flux increases at the initial period of operation of the fan 42, and after that, the heat flux becomes constant. The normal state of the filter 41 means that there is only a small amount of dirt and dust on the filter 41. At the initial period of operation of the fan 42, the rotation speed of the fan 42 gradually increases and the volume of air-flow generated by the fan 42 continuously increases. After that, the volume of air- flow generated by the fan 42 becomes constant.

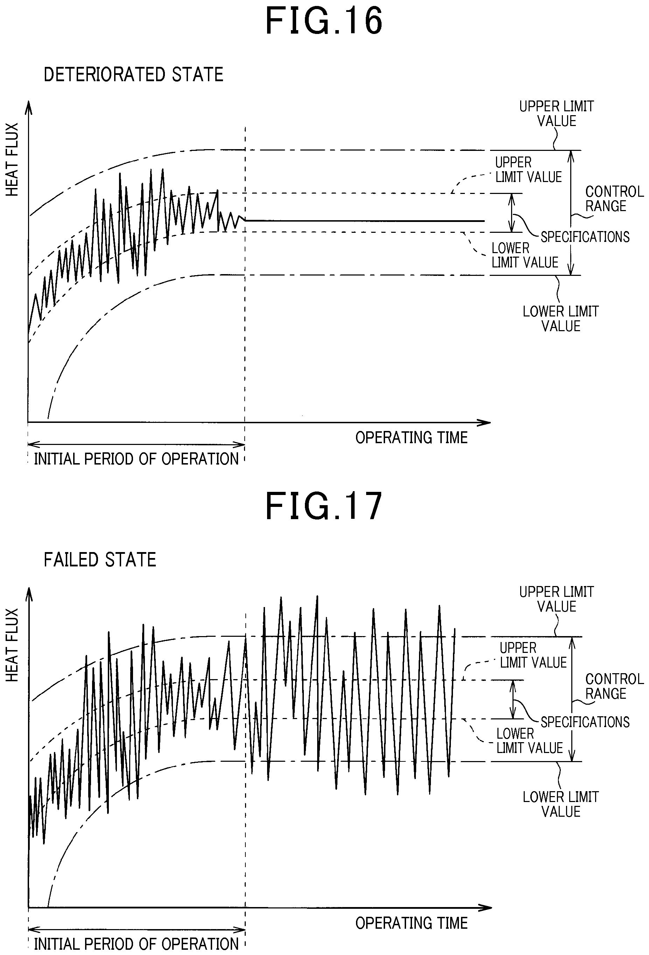

When the filter 41 enters the deteriorated state in which there is a greater amount of dirt and dust on the filter 41 than that in the normal state, the sound made at the initial period of operation becomes large and the heat flux increases as illustrated in Fig. 16. Further, when the filter 41 enters the failed state in which there is a still greater amount of dirt and dust on the filter 41 and the filter 41 needs replacement, the heat flux increases not only at the initial period of operation of the fan 42 but also at the subsequent periods as illustrated in Fig. 17. Accordingly, as illustrated in Figs. 15 to 17, the specifications are set with an upper limit value and a lower limit value to discriminate the normal state from the other states of the filter 41.

As illustrated in Fig. 15, when the filter 41 is in the normal state, the detection value falls within the specifications. Therefore, when the detection value falls within the specifications, a YES determination is made at step S12 and the process returns to step S11. When the detection value falls outside the specifications, a NO determination is made at step S12 and the process proceeds to step S13.

At step S13, it is determined whether the detection value falls within a control range. The control range is a second reference range for determining whether the filter 41 is in the deteriorated state. The control range is set with an upper limit value and a lower limit value to discriminate the deteriorated state from the failed state of the filter 41.

As illustrated in Fig. 16, when the filter 41 is in the deteriorated state, the detection value falls outside the specifications but falls within the control range at the initial period of operation. Therefore, when the detection value falls within the control range, a YES determination is made at step S13 and the process proceeds to step S14. At step S14, the display device 14 displays a notification of the abnormality. This allows maintenance personnel to take necessary measures such as replacement of the filter 41.

When the filter 41 is in the failed state, the detection value falls outside the control range at the initial period and subsequent periods of operation as illustrated in Fig. 17. Therefore, when the detection value falls outside the control range, a NO determination is made at step S13 and the process proceeds to step S16. At step S16, the rotation of the fan 42 is forcedly stopped. This allows maintenance personnel to take necessary measures such as replacement of the filter 41.

In this way, the condition-based maintenance of the filter 41 is performed.

As described above, according to the diagnostic apparatus 1 of the third embodiment, the use of the heat flux sensor 10 allows detection of an abnormality in the filter 41 without using a sound level meter.

### (Fourth embodiment)

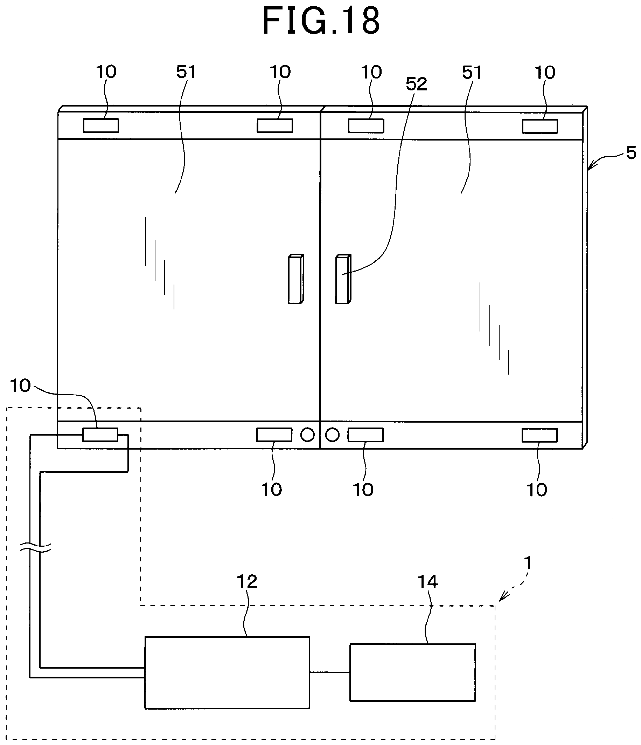

A diagnostic apparatus 1 of a fourth embodiment illustrated in Fig. 18 performs a preventive maintenance diagnosis of an automatic door device 5 as a measurement target.

The automatic door device 5 includes a door main body unit 51, a touch switch 52 for opening the door, and others. The door main body unit 51 slides in one direction along a guide rail not illustrated but positioned under the door main body unit 51. The door main body unit 51 is fixed to a door hanger not illustrated but positioned above the door main body unit 51. The door hanger is moved by a drive unit to move the door main body unit 51.

The diagnostic apparatus 1 is configured in the same manner as the first embodiment. A plurality of heat flux sensors 10 is mounted on the upper and lower portions of the door main body unit 51. Although Fig. 18 illustrates the state in which one of the heat flux sensors 10 is connected to a control device 12, all the heat flux sensors 10 are actually connected to the control device 12.

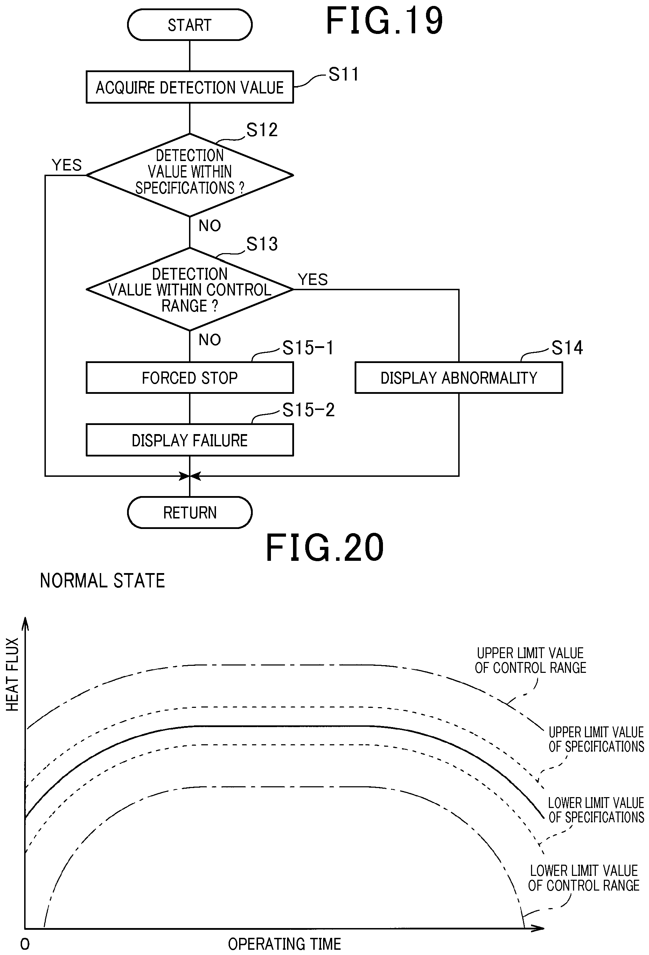

Next, the diagnostic control of preventive maintenance performed by the control device 12 of the fourth embodiment will be described. Heat flux is generated by the vibration of the sliding door main body unit 51 and the friction of the door main body unit 51 with the slide units such as the guide rail and the door hanger. The heat flux sensors 10 constantly measure the heat flux generated by the upper-side and lower-side portions of the door main body unit 51. The control device 12 determines the presence or absence of an abnormality based on the measured heat flux as described in the flowchart of Fig. 19. The process described in Fig. 19 is carried out from the start to stop of opening/closing operation of the door main body unit 51, that is, the start to stop of operation of the door main body unit 51.

At step S12, the detection value is compared to specifications to determine whether the detection value falls within the specifications. The specifications constitute a first reference range for determining whether the automatic door device 5 is in the normal state.

When the automatic door device 5 is in the normal state, the heat flux changes as illustrated in Fig. 20. Fig. 20 illustrates changes in the heat flux from the start to stop of movement of the door main body unit 51 turning from the full-closed state to the full-open state. The door main body unit 51 moves slowly for a specific period of time immediately after the start of movement and for a specific period of time before the stop of movement. Accordingly, as illustrated in Fig. 20, the heat flux increases after the start of movement, then becomes constant, and then decreases.

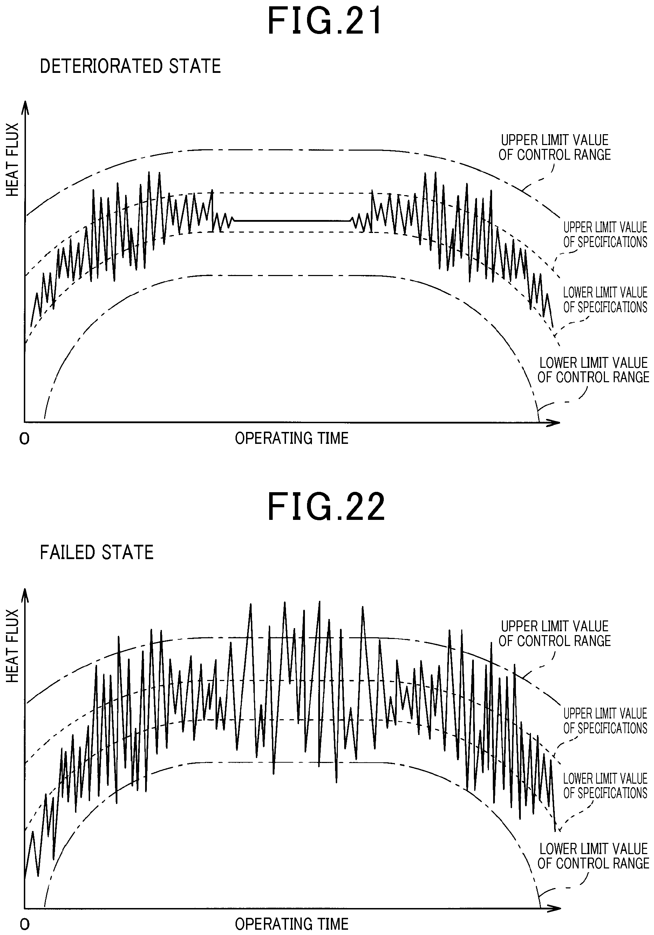

When the automatic door device 5 is in the deteriorated state, the heat flux changes as illustrated in Fig. 21. The deteriorated state refers to the state in which the guide rail has foreign matter lodged therein or the door hanger has a decrease in lubricant. In the deteriorated state, the heat flux increases with strong vibration and friction for a specific period of time immediately after the start of movement and for a specific period of time before the stop of movement.

When the automatic door device 5 is in the failed state, the heat flux changes as illustrated in Fig. 22. The failed state refers to the state in which the guide rail has more foreign matter than that in the deteriorated state or the door hanger lacks a lubricant. In the failed state, the heat flux increases with strong vibration and friction from the start to stop of movement.

Accordingly, as illustrated in Figs. 20 to 22, the specifications are set with an upper limit value and a lower limit value to discriminate the normal state from the other states of the automatic door device 5.

As illustrated in Fig. 20, when the automatic door device 5 is in the normal state, the detection value falls within the specifications. Therefore, when the detection value falls within the specifications, a YES determination is made at step S12 and the process returns to step S11. When the detection value falls outside the specifications, a NO determination is made at step S12 and the process proceeds to step S13.

At step S13, it is determined whether the detection value falls within a control range. The control range is a second reference range for determining whether the automatic door device 5 is in the deteriorated state. The control range is set with an upper limit value and a lower limit value to discriminate the deteriorated state from the failed state of the automatic door device 5.

As illustrated in Fig. 21, when the automatic door device 5 is in the deteriorated state, the detection value falls outside the specifications but falls within the control range for a specific period of time immediately after the start of movement and for a specific period of time before the stop of movement. Therefore, when the detection value falls within the control range, a YES determination is made at step S13 and the process proceeds to step S14. At step S14, the display device 14 displays a notification of the abnormality. This allows maintenance personnel to take necessary measures such as removal of foreign matter or recharging of a lubricant.

When the automatic door device 5 is in the failed state, as illustrated in Fig. 22, the detection value falls outside the control range for a period of time from the start to stop of movement. Therefore, when the detection value falls outside the control range, a NO determination is made at step S13 and the process proceeds to step S15-1. At step S15-1, the automatic door device 5 is forcedly stopped. Subsequently, at step S15-2, the display device 14 displays a notification of the failure.

In this way, the condition-based maintenance of the automatic door device 5 is performed.

As described above, according to the diagnostic apparatus 1 of the fourth embodiment, the use of the heat flux sensor 10 allows detection of an abnormality in the automatic door device 5 without using a vibration meter.

### (Fifth embodiment)

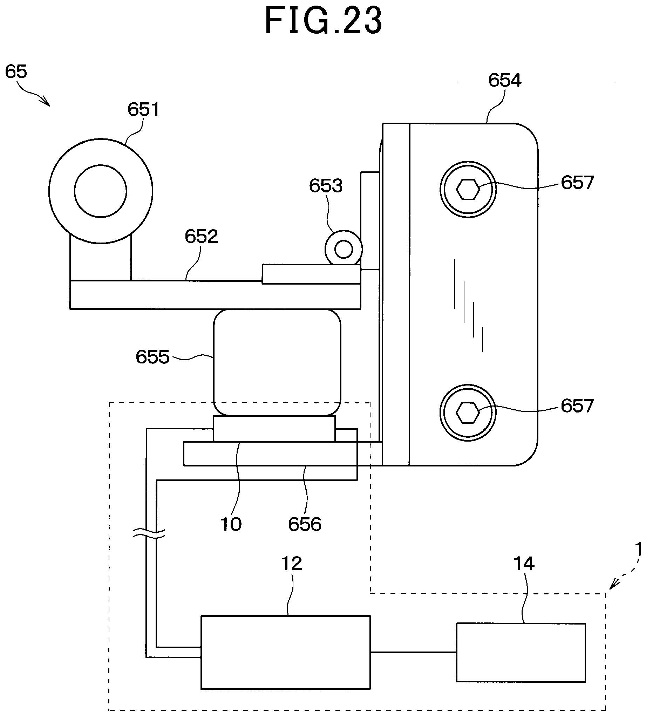

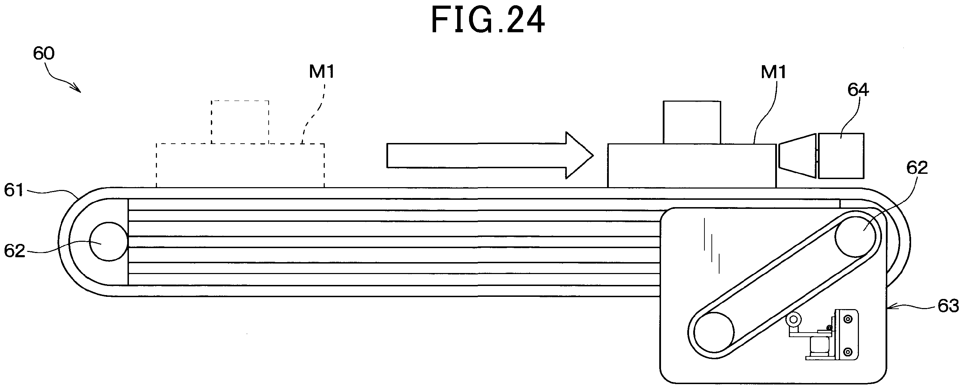

A diagnostic apparatus 1 of a fifth embodiment illustrated in Fig. 23 performs a preventive maintenance diagnosis of a conveyance belt 61 in a belt conveyor 60 illustrated in Fig. 24 as a measurement target.

As illustrated in Fig. 24, the belt conveyor 60 is a conveyance device that rotates the loop-like conveyance belt 61 on a plurality of rollers 62 to move a conveyance article M1 placed on the conveyance belt 61. The belt conveyor 60 includes the conveyance belt 61, the rollers 62, a drive unit 63, and a stopper 64. The drive unit 63 is a drive unit that rotates the rollers 62. The drive unit 63 rotates the rollers 62 to move the conveyance belt 61. The stopper 64 is a member that stops the conveyance article M1 at a predetermined stop position.

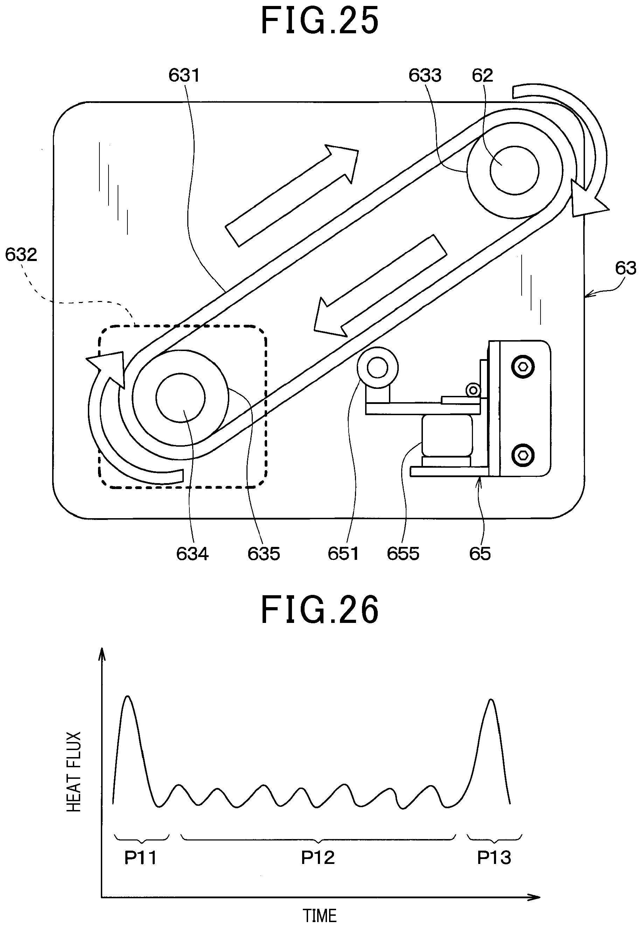

As illustrated in Fig. 25, the drive unit 63 includes a drive belt 631, a motor 632, and a tensioner 65.

The drive belt 631 transfers the power of the motor 632 to the roller 62. The drive belt 631 is hung around both a driven pulley 633 provided on the roller 62 rotated by the drive unit 63 and a driving pulley 635 provided on a drive shaft 634 of the motor 632. The tensioner 65 applies tension to the drive belt 631.

As illustrated in Fig. 23, the tensioner 65 includes a tensioner roller 651, a roller receiving plate 652, a hinge 653, an attachment stay 654, an elastic body 655, and an elastic body holding plate 656.

The tensioner roller 651 is a contact unit in contact with the drive belt 631. The tensioner roller 651 is held by a leading end of the roller receiving plate 652. The roller receiving plate 652 is supported by the attachment stay 654 via the hinge 653. The elastic body 655 is disposed on the side of the roller receiving plate 652 opposite to the tensioner roller 651.

The elastic body 655 is in contact with the roller receiving plate 652. The elastic body 655 applies tension to the drive belt 631 via the roller receiving plate 652 and the tensioner roller 651. The elastic body 655 deforms depending on fluctuations in tension on the drive belt 631. The elastic body 655 is formed from a synthetic rubber such as urethane rubber. The elastic body holding plate 656 holds the elastic body 655. The elastic body holding plate 656 is supported by the attachment stay 654. The attachment stay 654 is fixed by bolts 657 to the main body unit of the drive unit 63.

A heat flux sensor 10 is installed between the elastic body 655 and the elastic body holding plate 656. The diagnostic apparatus 1 is configured in the same manner as the first embodiment.

Next, the diagnostic control of preventive maintenance performed by the control device 12 of the fifth embodiment will be described. Heat flux is generated by deformation of the elastic body 655 during operation of the belt conveyor 60. The diagnostic apparatus 1 uses the heat flux sensor 10 to measure constantly the heat flux generated by the elastic body 655.

When the conveyance belt 61 is in the normal state, as illustrated in Fig. 26, the heat flux changes with the lapse of time in a first period P11, a second period P12, and a third period P13 in a conveyance process. The conveyance process is a process in which the stopped belt conveyor 60 starts operation to convey the conveyance article M1 on the conveyance belt 61 from an initial position to a predetermined stop position, and then the belt conveyor 60 stops operation. Therefore, the conveyance process is a process from the start to stop of driving of the motor 632.

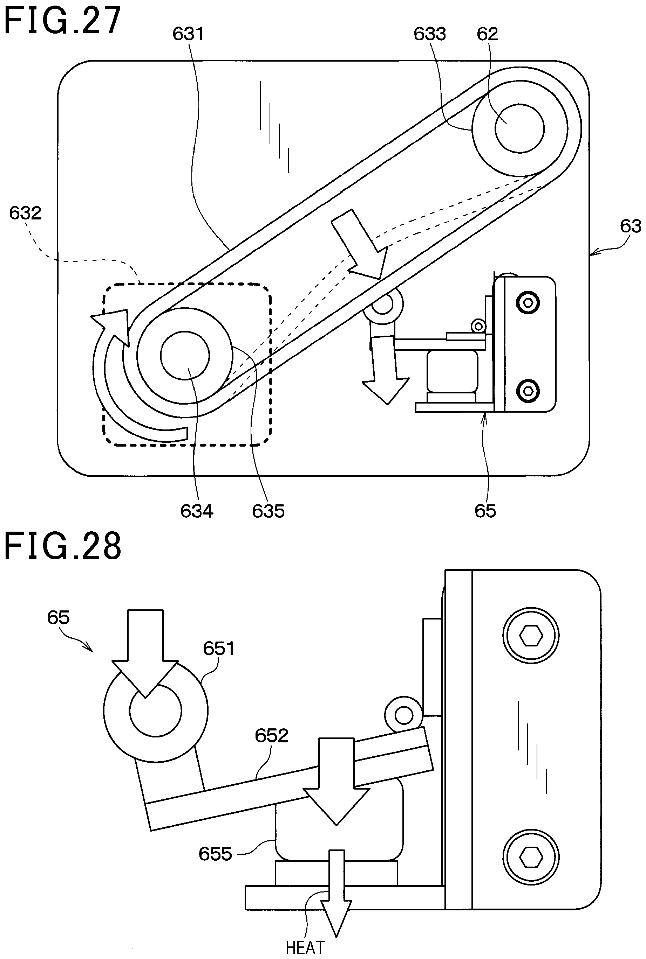

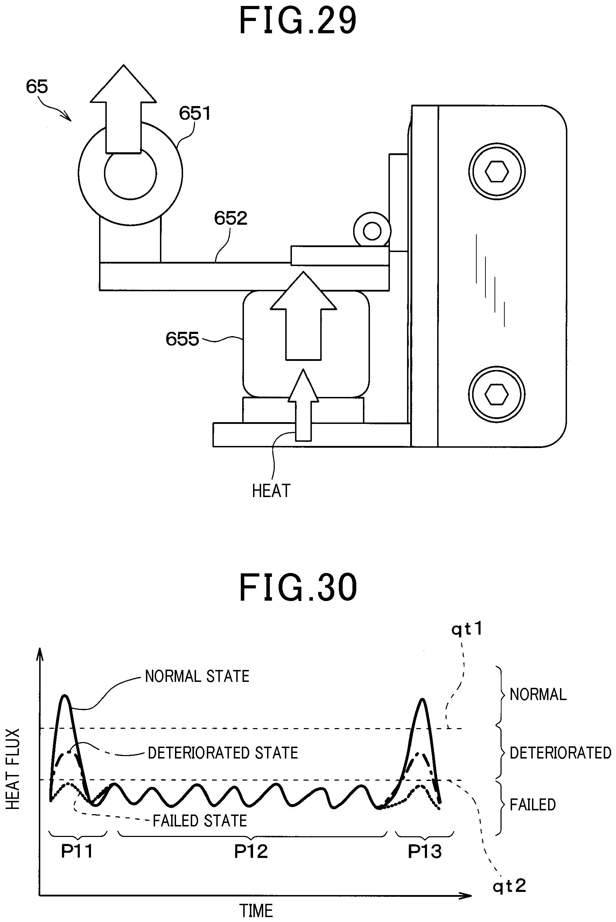

The first period P11 is a predetermined period immediately after the start of driving of the motor 632. At the initial stage of the conveyance process, the conveyance article M1 is placed on the stopped conveyance belt 61. When the motor 632 starts to drive, the driving pulley 635 begins rotating. However, the driven pulley 633 does not rotate so quickly immediately after the start of driving by the motor 632 due to the inertia of the conveyance article M1 on the conveyance belt 61. Accordingly, as illustrated in Fig. 27, the drive belt 631 turns from the state shown by dashed lines to the tensioned state shown by solid lines. Therefore, as illustrated in Fig. 28, the tensioner roller 651 is pressed downward. Then, the elastic body 655 is compressed to radiate heat. When the driven pulley 633 starts rotation, the elastic body 655 recovers its original shape as illustrated in Fig. 29. Accordingly, the tensioner roller 651 returns upward. At that time, the elastic body 655 absorbs heat.

As a result, in the first period P11, the heat flux increases until the conveyance article M1 starts to move. Once the conveyance article M1 starts movement, the heat flux decreases.

The second period P12 is a period during which the conveyance article M1 moves with the conveyance belt 61. In this period, the tension on the drive belt 631 changes with the timing when the teeth of the drive belt 631 engage with or disengage from the teeth of the driven pulley 633 and the driving pulley 635. Accordingly, depending on the change, the tensioner roller 651 moves upward or downward. This causes alternately the compression and restoration of the elastic body 655. Consequently, as illustrated in Fig. 26, a vibration waveform of the heat flux is generated.

The third period P13 is a predetermined period immediately after the arrival of the conveyance article M1 at a predetermined stop position. When the conveyance article M1 reaches the predetermined stop position, the conveyance article M1 abuts with the stopper 64 and stops while the conveyance belt 61 continuously moves. Accordingly, the friction between the conveyance belt 61 and the conveyance article M1 exerts a force of stopping the driven pulley 633. Therefore, as in the first period P11, the drive belt 631 is tensioned. The tensioner roller 651 is thus pressed downward as illustrated in Fig. 28. The elastic body 655 is then compressed to radiate heat. After that, the arrival of the conveyance article M1 at the predetermined stop position is confirmed, and the motor 632 stops operation. Consequently, as illustrated in Fig. 26, the heat flux increases and then decreases to 0.

When the conveyance belt 61 is in the normal state, the peaks of the heat flux are seen in the first period P11 and the third period P13.

When the conveyance belt 61 is in the deteriorated state, the heat flux changes with the lapse of time as illustrated in Fig. 30. The deteriorated state refers to the state in which the surface of the conveyance belt 61 is worn or the conveyance belt 61 loses elasticity as compared to the initial state of the conveyance belt 61.

More specifically, the continuous use of the belt conveyor 60 wears the surface of the conveyance belt 61. When the conveyance belt 61 becomes worn, the frictional force between the conveyance belt 61 and the conveyance article M1 decreases to cause slippage between the two. As the slippage is larger, it takes more time to convey an object, thereby lengthening the cycle time of the conveyance process.

The conveyance belt 61 is operated by the rotation of the rollers 62 due to the friction with the rollers 62 under tension. Being continuously used, the conveyance belt 61 gradually loses elasticity. When the conveyance belt 61 loses elasticity, the tension on the conveyance belt 61 decreases and the force of friction with the rollers 62 reduces. This causes slippage between the conveyance belt 61 and the rollers 62.

When the frictional force between the conveyance belt 61 and the conveyance article M1 or the frictional force between the conveyance belt 61 and the rollers 62 reduces, the drive belt 631 is less prone to be tensioned at the start of driving of the motor 632 and at the stoppage of the conveyance article M1 by the stopper 64, as compared to the normal state. Accordingly, when the conveyance belt 61 is in the deteriorated state, the heights of the peaks of the heat flux detected in the first period P11 and the third period P13 become smaller than those in the normal state.

In addition, when the conveyance belt 61 is in the failed state, the heat flux changes as illustrated in Fig. 30. The failed state refers to the state in which the conveyance belt 61 and the conveyance article M1 completely slip on each other or the state in which the conveyance belt 61 and the rollers 62 completely slip on each other. In the failed state, the changes in the heat flux detected in the first period P11 and the third period P13 generate the same vibration waveform as that in the second period P12.

Accordingly, as illustrated in Fig. 30, the control device 12 uses a first threshold qt1 set to discriminate the normal state from the other states of the conveyance belt 61 and a second threshold qt2 set to discriminate the deteriorated state from the failed state of the conveyance belt 61. The second threshold qt2 is set to a value smaller than the first threshold qt1. The control device 12 compares the detection value from the heat flux sensor 10 to these thresholds. This makes it possible to detect whether the conveyance belt 61 is in the normal state, the deteriorated state, or the failed state.

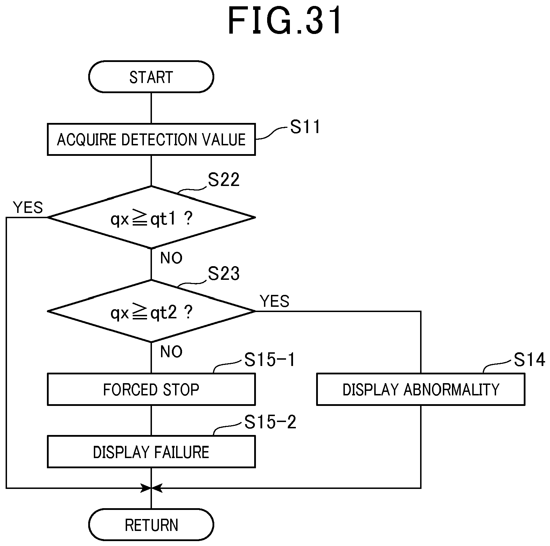

Specifically, as described in the flowchart of Fig. 31, the control device 12 determines the presence or absence of an abnormality based on the measured heat flux. The process described in Fig. 31 is carried out from the start to stop of driving by the motor 632.

At step S11, detection value qx from the heat flux sensor 10 is acquired.

After that, at step S22, the detection value qx and the first threshold qt1 are compared to determine whether the detection value qx is equal to or greater than the first threshold qt1. In this case, the detection value in the first period P11 or the third period P13 is used. As illustrated in Fig. 30, when the conveyance belt 61 is in the normal state, the detection value qx is equal to or greater than the first threshold qt1. Accordingly, when the detection value qx is equal to or greater than the first threshold qt1, a YES determination is made at step S22, and the flow of process described in Fig. 31 is terminated. Then, step S11 is performed again. On the other hand, when the detection value qx is smaller than the first threshold qt1, a NO determination is made at step S22, and the process proceeds to step S23.

At step S23, it is determined whether the detection value qx is equal to or greater than the second threshold qt2. As illustrated in Fig. 30, when the conveyance belt 61 is in the deteriorated state, the detection value qx is equal to or greater than the second threshold qt2. Accordingly, when the detection value qx is equal to or greater than the second threshold qt2, a YES determination is made at step S23, and the process proceeds to step S14. At step S14, the display device 14 displays a notification of the abnormality. This allows maintenance personnel to take necessary measures such as replacement of the conveyance belt 61.

Meanwhile, when the conveyance belt 61 is in the failed state, the detection value qx is smaller than the second threshold qt2. Accordingly, when the detection value qx is smaller than the second threshold qt2, a NO determination is made at step S23, and the process proceeds to step S15-1. At step S15-1, the belt conveyor 60 is forcedly stopped. Subsequently, at step S15-2, the display device 14 displays a notification of the failure. This allows maintenance personnel to take necessary measures.

In this way, the condition-based maintenance of the belt conveyor 60 is performed. As described above, according to the diagnostic apparatus 1 of the fifth embodiment, the use of the heat flux sensor 10 allows detection of an abnormality in the belt conveyor 60.

### (Sixth embodiment)

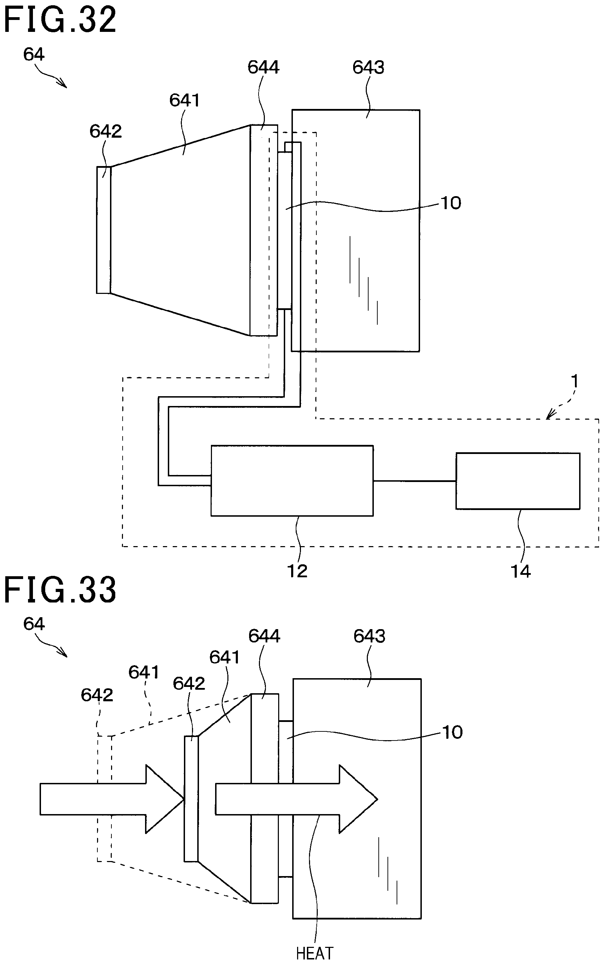

The diagnostic apparatus 1 of a sixth embodiment illustrated in Fig. 32 performs a preventive maintenance diagnosis of the stopper 64 in the belt conveyor 60 illustrated in Fig. 24 as a measurement target.

As illustrated in Fig. 32, the stopper 64 includes an elastic body 641, a receiving plate 642, and an attachment block 643. The elastic body 641 is a buffer member. The receiving plate 642 is a member with which a flowing conveyance article M1 is brought into direct contact. The receiving plate 642 is a protection member that keeps the elastic body 641 from being damaged. The receiving plate 642 is fixed to a structure body not illustrated in the belt conveyor 60. The heat flux sensor 10 is interposed between the elastic body 641 and the attachment block 643. A protection plate 644 is installed between the heat flux sensor 10 and the elastic body 641. The protection plate 644 is a member that prevents the heat flux sensor 10 from being damaged due to deformation of the elastic body 641 when the heat flux sensor 10 is attached directly to the elastic body 641.

The elastic body 641 is formed from urethane rubber, for example. The receiving plate 642, the attachment block 643, and the protection plate 644 are formed from metal such as stainless steel or aluminum. The adjacent members are bonded by an adhesive or gluing agent.

As illustrated in Fig. 24, the conveyance article M1 on the conveyance belt 61 travels toward the stopper 64. The conveyance article M1 hits against the stopper 64 and stops. At that time, the conveyance article M1 contacts the surface of the receiving plate 642. The conveyance article M1 causes the elastic body 641 to deform in such a manner as to crush and turn from the state shown by dashed lines to the state shown by solid lines in Fig. 33. The deformed elastic body 641 generates heat. The generated heat passes through the protection plate 644 and the heat flux sensor 10 and flows into the receiving plate 642 as shown by the arrow in Fig. 33. The heat flux sensor 10 detects heat flux of the heat radiated from the elastic body 641.

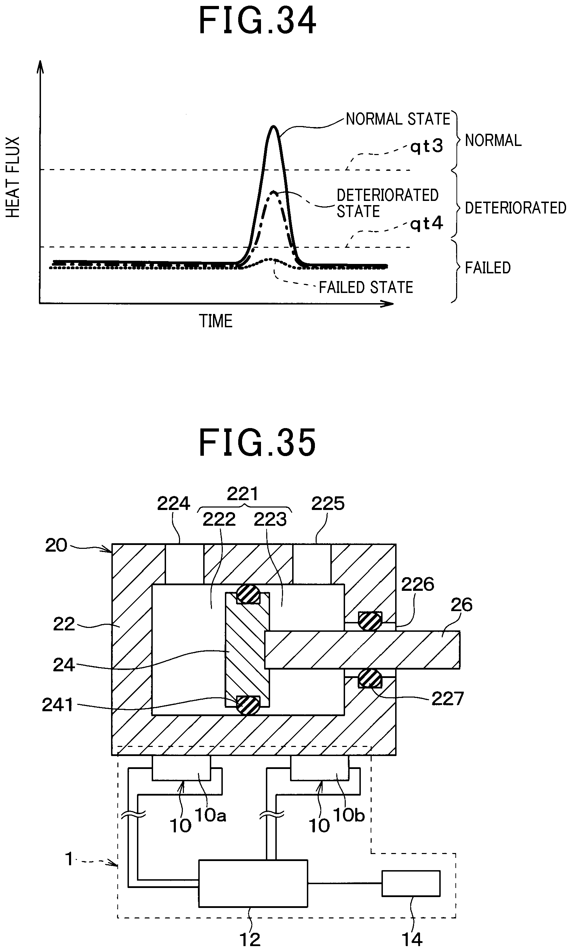

When the conveyance article M1 collides with the stopper 64, the elastic body 641 causes compressive deformation and generates heat. This heat is produced due to conversion from the kinetic energy of the conveyance article M1. Accordingly, when the elastic body 641 of the stopper 64 is in the normal state, the heat flux changes with the lapse of time as illustrated in Fig. 34. Specifically, when the conveyance article M1 collides with the stopper 64, the heat flux waveform has a peak.

When the stopper 64 is used for a long period of time, the elastic body 641 becomes deteriorated and hard by oxidation of the rubber. In addition, the repeated deformation causes fatigue breaking or cracking to the elastic body 641, which finally leads to breakage. With such deterioration or fatigue, the elastic body 641 is less prone to elastic deformation and its kinetic energy cannot convert into heat. Accordingly, when the elastic body 641 of the stopper 64 is in the deteriorated state, the peak of the heat flux waveform at the time of collision between the conveyance article M1 and the stopper 64 becomes smaller than that in the normal state as illustrated in Fig. 34.

When the deterioration or fatigue of the elastic body 641 proceeds, the elastic body 641 is damaged and enters the failed state. In the failed state, the peak of the heat flux waveform is hardly seen as illustrated in Fig. 34.

As illustrated in Fig. 34, a first threshold qt3 is set to discriminate the normal state from the other states of the elastic body 641, and a second threshold qt4 is set to discriminate the deteriorated state from the failed state of the elastic body 641. The second threshold qt4 is set to be a smaller value than the first threshold qt3.

Then, as in the fifth embodiment, the control device 12 performs a preventive maintenance diagnosis of the elastic body 641 using the first threshold qt3 and the second threshold qt4 as described in Fig. 31. In the sixth embodiment, the first threshold qt1 and the second threshold qt2 described in Fig. 31 are replaced respectively with the first threshold qt3 and the second threshold qt4. This makes it possible to detect whether the elastic body 641 is in the normal state, the deteriorated state, and the failed state.

### (Seventh embodiment)

A diagnostic device 1 of a seventh embodiment illustrated in Fig. 35 performs a preventive maintenance diagnosis of seal members 241 and 227 of an air cylinder 20 as a measurement target.

The air cylinder 20 is used to convey a conveyance article M1. The air cylinder 20 is a power cylinder that reciprocates a piston 24 with air pressure as power. The air cylinder 20 includes a cylinder 22, the piston 24, and a piston rod 26. The cylinder 22, the piston 24, and the piston rod 26 are made from metal.

The cylinder 22 is a housing that has a cylindrical internal space (that is, chamber) 221. Accordingly, the cylinder 22 is also called cylinder housing. The chamber 221 is divided by the piston 24 into two chambers: a first chamber 222 and a second chamber 223. The first chamber 222 is a chamber on the side of the piston 24 opposite to the piston rod 26. The second chamber 223 is a chamber on the side of the piston 24 with the piston rod 26. The cylinder 22 has a first opening portion 224 communicating to the first chamber 222. The cylinder 22 has a second opening portion 225 communicating to the second chamber 223.

The piston 24 is disposed in the chamber 221. Rubber seal members 241 are attached to side surfaces of the piston 24. The seal members 241 seal between the piston 24 and the cylinder 22. The seal members 241 cause the piston 24 to slide on an inner surface of the cylinder 22.

The piston rod 26 is a shaft member cooperating with the piston 24. The cylinder 22 has a third opening portion 226. The piston rod 26 passes through the third opening portion 226. Rubber seal members 227 are attached to an inner wall surface constituting the third opening portion 226. The seal members 227 seal between the piston rod 26 and the cylinder 22. The seal members 227 cause the piston rod 26 to slide on the inner surface of the cylinder 22.

The cylinder 22 has the first opening portion 224 and the second opening portion 225 connected to flow path switch valves not illustrated. The flow path switch valves are designed to switch between the connection with an air supply flow path not illustrated and the connection with an air discharge flow path not illustrated for each of the first opening portion 224 and the second opening portion 225. The air supply flow path is connected to an air compressor not illustrated as a supply source of compressed air. The air discharge flow path is open to the atmosphere. The flow path switch valves switch between a first state in which the compressed air is supplied to the first chamber 222 and the second chamber 223 is open to the atmosphere and a second state in which the first chamber 222 is open to the atmosphere and the compressed air is supplied to the second chamber 223.

The diagnostic apparatus 1 includes heat flux sensors 10, a control device 12, and a display device 14. The heat flux sensors 10 detect heat flux between the inside and outside of the cylinder 22. The heat flux sensors 10 are attached to the outer surface of the cylinder 22. In the seventh embodiment, the heat flux sensors 10 include a first heat flux sensor 10a and a second heat flux sensor 10b. The first heat flux sensor 10a is disposed on an outer surface of the cylinder 22 at a position closest to the first chamber 222. The first heat flux sensor 10a detects heat flux between the inside and outside of the first chamber 222. The second heat flux sensor 10b is disposed on an outer surface of the cylinder 22 at a position closest to the second chamber 223. The second heat flux sensor 10b detects the heat flux between the inside and outside of the second chamber 223.

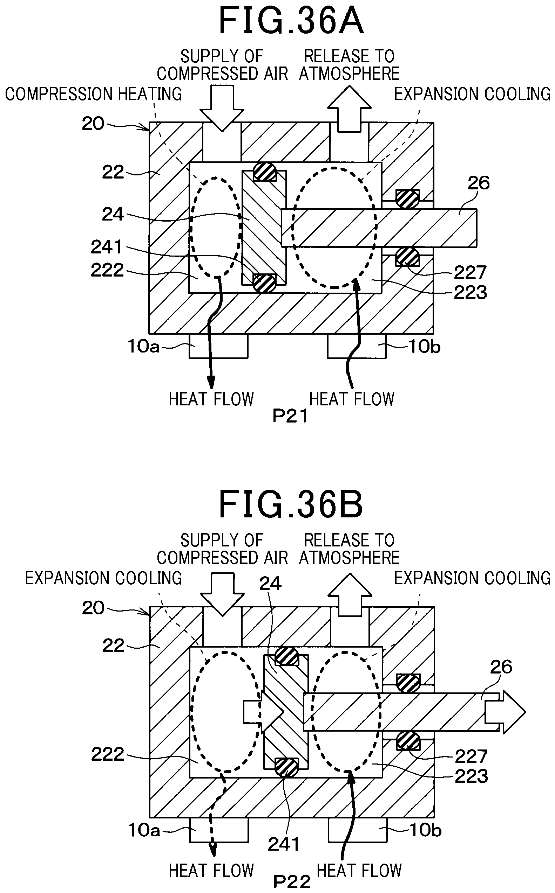

Next, heat flux changes with the lapse of time with the seal members 241 and 227 in the normal state will be described with reference to Figs. 36A to 36D.

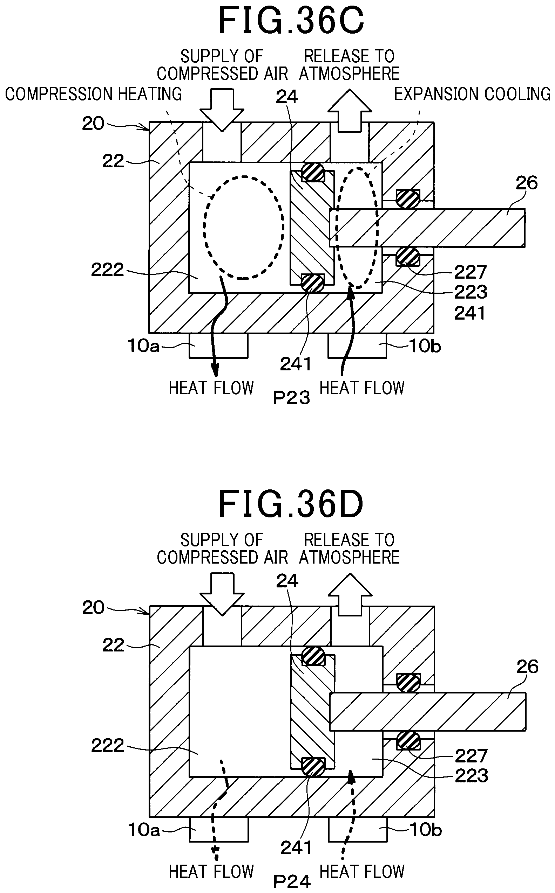

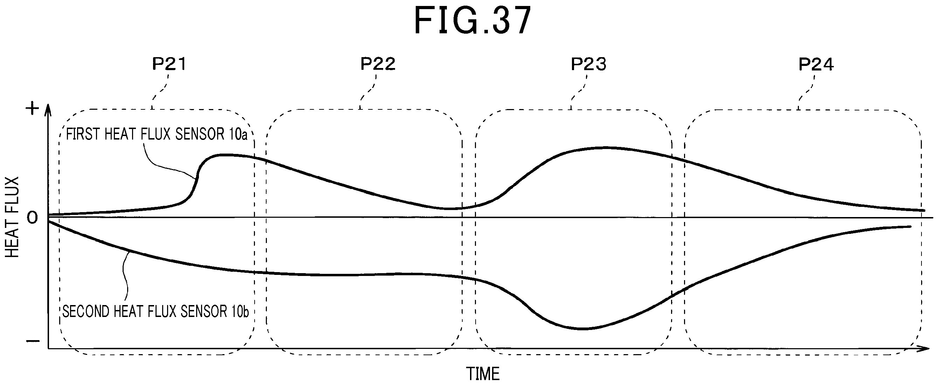

Figs. 36A to 36D illustrate a case in which the extending and contracting directions of the air cylinder 20 (that is, the movement directions of the piston 24) are rightward and leftward directions, and the air cylinder 20 switches from the contracted state to the extended state. In this case, the heat flux changes have waveforms illustrated in Fig. 37. The horizontal axis illustrated in Fig. 37 indicates the time elapsed from the start of supply of the compressed air to the air cylinder 20. The vertical axis illustrated in Fig. 37 indicates the magnitudes of the heat fluxes detected by the first heat flux sensor 10a and the second heat flux sensor 10b. The heat flux traveling from the inside to outside of the chamber is set on the positive side. The heat flux traveling from the outside to inside of the chamber is set on the negative side. Periods P21, P22, P23, and P24 illustrated in Fig. 37 correspond respectively to the states of the air cylinder 20 illustrated in Figs. 36A, 36B, 36C, and 36D.

In the period P21, as illustrated in Fig. 36A, the air cylinder 20 switches from the contracted state to the extended state, the compressed air is supplied to the first chamber 222, and the second chamber 223 is open to the atmosphere. In this case, the second chamber 223 switches from the state with a supply of the compressed air at the time of turning from the extended state to the contracted state, to the state of being open to the atmosphere. In the period P1, the piston 24 does not move due to the presence of static friction of the seal members 241 and 227. With a rise in the pressure of the first chamber 222, the air in the first chamber 222 is compressed and heated. This increases the heat flux traveling from the inside to outside of the first chamber 222. This increases the heat flux detected by the first heat flux sensor 10a (hereinafter, called first heat flux) on the positive side. Meanwhile, the second chamber 223 is brought under a reduced pressure by opening to the atmosphere and the air in the first chamber 222 is expanded and cooled. This increases the heat flux traveling from the inside to outside of the second chamber 223. Accordingly, the heat flux detected by the second heat flux sensor 10b (hereinafter, called second heat flux) takes a minus value, thereby leading to increase in the absolute value on the negative side.

In the period P22, as illustrated in Fig. 36B, the pressure difference between the first chamber 222 and the second chamber 223 increases and the piston 24 starts to move. When the piston 24 starts to move, the air in the first chamber 222 expands and the pressure in the first chamber 222 reduces. Accordingly, the air in the first chamber 222 is cooled. This decreases the first heat flux. In contrast, the air in the second chamber 223 is compressed and the reduced-pressure state becomes moderate. This slows down changes in the second heat flux.

In the period P23, as illustrated in Fig. 36C, the piston 24 is stopped by a stopper not illustrated. Accordingly, the expansion of the air in the first chamber 222 stops and the pressure in the first chamber 222 rises again. When the air is compressed and heated, the first heat flux increases on the positive side. Meanwhile, due to the stop of the piston 24, the compression of the air in the second chamber 223 stops as well. Accordingly, the pressure reduction in the second chamber 223 further proceeds. This abruptly increases the absolute value of the second heat flux on the - side.

In the period P24, as illustrated in Fig. 36D, the compressed air is supplied to the first chamber 222 until the first chamber 222 reaches a predetermined pressure. When the first chamber 222 reaches the predetermined pressure, the supply of the compressed air is stopped. This saturates heating of the air in the first chamber 222 so that the first heat flux gradually decreases and comes closer to 0. The second chamber 223 comes closer to the state under the atmospheric air pressure. Accordingly, the second heat flux gradually decreases and comes closer to 0.

In this way, the heat flux changes with the lapse of time depending on changes in the gas pressure.

When the air cylinder 20 switches from the extended state to the contracted state, the output waveform of the first heat flux sensor 10a and the output waveform of the second heat flux sensor 10b are exchanged from the output waveforms illustrated in Fig. 37.

When the air cylinder 20 is used for a long period of time, the seal members 241 and 227 become worn. The wearing of the seal members 241 and 227 lowers the airtightness of the chamber 221. With the low airtightness of the chamber 221, the air pressure drops. Accordingly, the power and working speed of the piston rod 26 become lower. In this case, the cycle time increases. Additionally, a chuck cylinder would cause a chuck error. Eventually, the facility is stopped.

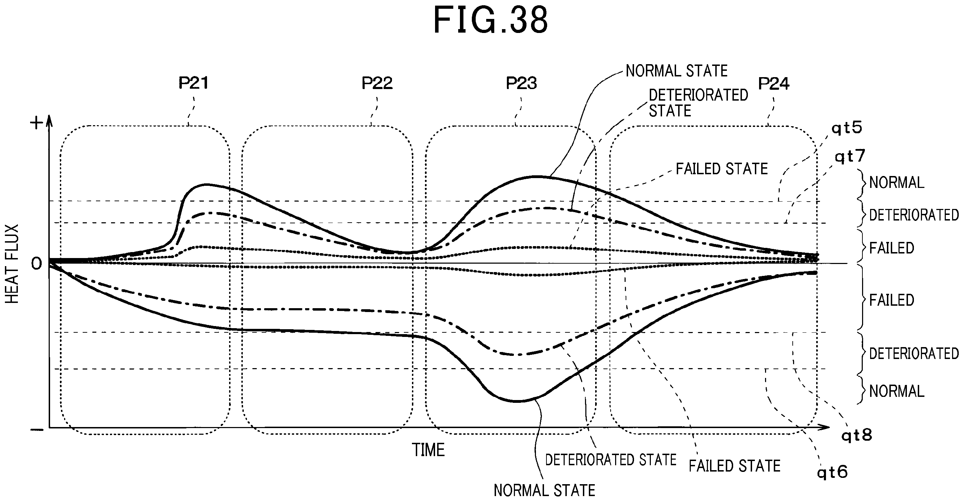

With the wearing of the seal members 241 and 227, the change in pressure of the chamber 221 becomes minor. Accordingly, when the seal members 241 and 227 are in the deteriorated state, the heat flux change with the lapse of time is smaller than that in the normal state as illustrated in Fig. 38.

When the seal members 241 and 227 become further worn and the air cylinder 20 no longer moves, the pressure of the chamber 221 hardly changes. Accordingly, when the seal members 241 and 227 are in the failed state, the heat flux change with the lapse of time is further minor than that in the deteriorated state as illustrated in Fig. 38.

Accordingly, as illustrated in Fig. 38, first thresholds qt5 and qt6 are set to discriminate the normal state from the other states of the seal members 241 and 227, and second thresholds qt7 and qt8 are set to discriminate the deteriorated state from the failed state of the seal members 241 and 227. The second thresholds qt7 and qt8 are set to smaller absolute values than the first thresholds qt5 and qt6.

As in the fifth embodiment, the control device 12 performs the preventive maintenance diagnosis described in the flowchart of Fig. 31, using a detection value qx1 of the first heat flux sensor 10a, the first threshold qt5, and the second threshold qt7. As the detection value qx1, the detection value in the first period P21 or the third period P23 is used. In this case, the detection value qx, the first threshold qt1, and the second threshold qt2 described in Fig. 31 are respectively replaced with the detection value qx1, the first threshold qt5, and the second threshold qt7.

As in the fifth embodiment, the control device 12 performs the preventive maintenance diagnosis described in the flowchart of Fig. 31, using a detection value qx2 of the second heat flux sensor 10b, the first threshold qt6, and the second threshold qt8. As the detection value qx2, the detection value in the third period P23 is used. In this case, the detection value qx, the first threshold qt1, and the second threshold qt2 described in Fig. 31 are respectively replaced with the detection value qx2, the first threshold qt6, and the second threshold qt8.

This makes it possible to detect whether the seal members 241 and 227 are in the normal state, the deteriorated state, or the failed state. The preventive maintenance diagnosis may be made using only either the first heat flux sensor 10a or the second heat flux sensor 10b.

### (Eighth embodiment)

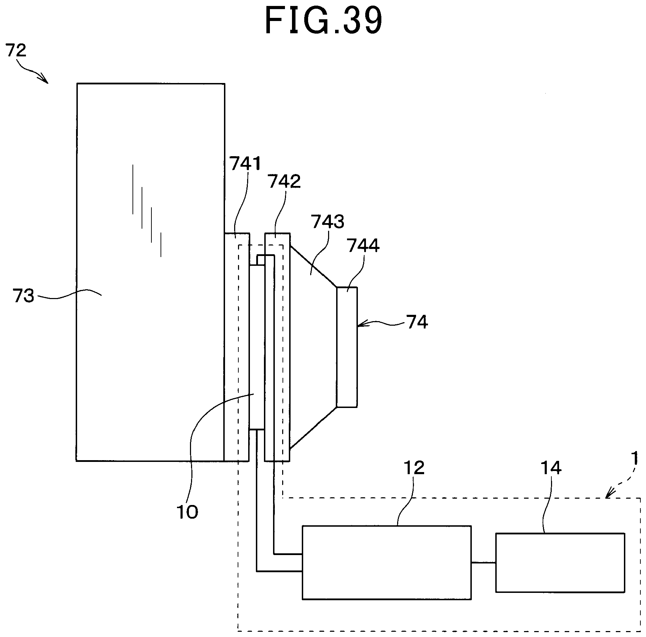

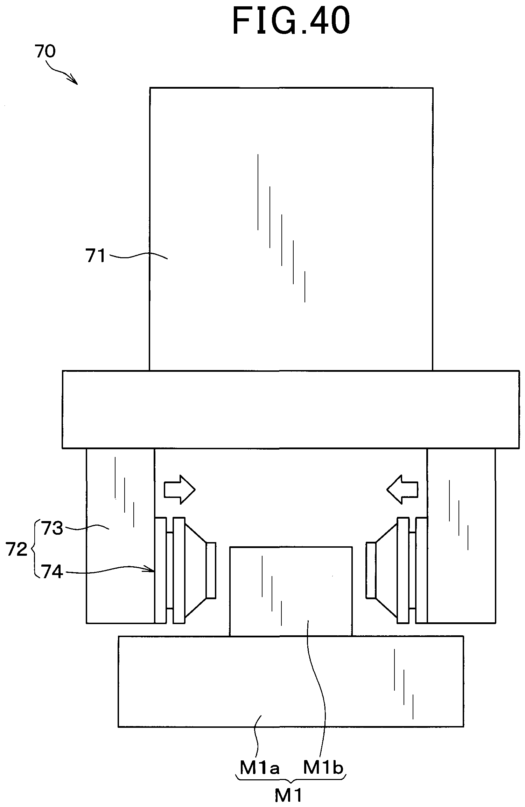

A diagnostic apparatus 1 of an eighth embodiment illustrated in Fig. 39 performs a preventive maintenance diagnosis of an elastic body 743 of a chuck device 70 as a measurement target illustrated in Fig. 40.

The chuck device 70 is used to convey a conveyance article M1. The chuck device 70 grasps the conveyance article M1. The conveyance article M1 includes a grasp portion M1b protruding from a main body portion M1a. The conveyance article M1 is grasped at the grasp portion M1b.

The chuck device 70 has a plurality of chuck pawls 72 opened and closed by a chuck cylinder 71. The plurality of chuck pawls 72 grasps the conveyance article M1. Each of the chuck pawls 72 has a main body portion 73 that moves in the opening and closing directions of the chuck pawl 72 and a leading end portion 74 that is in contact with the conveyance article M1. The leading end portion 74 is bonded to the main body portion 73.

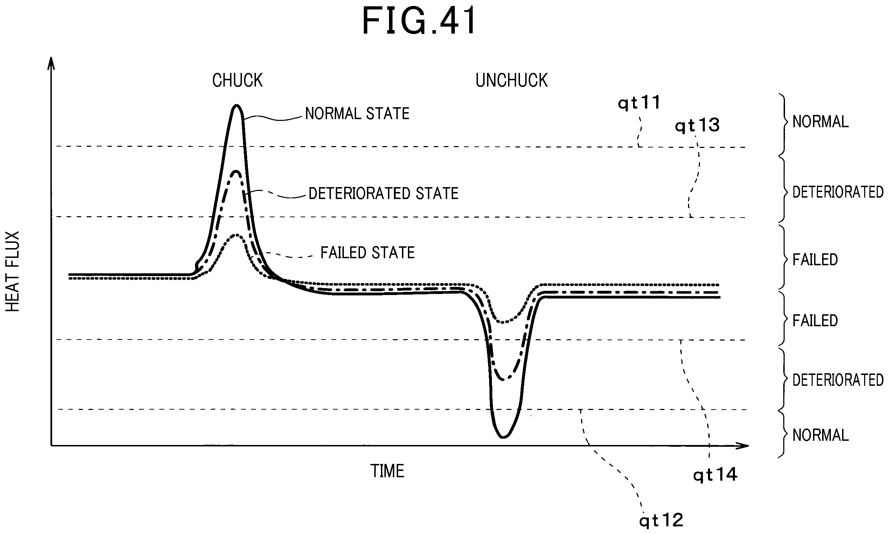

As illustrated in Fig. 41, the leading end portion 74 has an attachment plate 741, a heat flux sensor 10, a protection plate 742, the elastic body 743, and a receiving plate 744 in order from the main body portion 73 side.

The attachment plate 741 is attached to the main body portion 73. The attachment plate 741 is a member for attaching the elastic body 743 and the like to the main body portion 73. The heat flux sensor 10 is interposed between the attachment plate 741 and the protection plate 742. The heat flux sensor 10 is fixed to the elastic body 743 via the protection plate 742. The protection plate 742 is a member that prevents the heat flux sensor 10 from being broken due to the deformation of the elastic body 743 when the heat flux sensor 10 is stuck directly to the elastic body 743. The elastic body 743 is a buffer member. The elastic body 743 also plays the role of grasping the conveyance article M1 by the spring force of elastic deformation.

The elastic body 743 is formed from urethane rubber. The attachment plate 741, the protection plate 742, and the receiving plate 744 are formed from metal such as stainless steel or aluminum. The adjacent members are bonded by an adhesive or gluing agent.

When the plurality of chuck pawls 72 are closed to chuck the conveyance article M1, the elastic body 743 is compressed to generate heat. When the plurality of chuck pawls 72 are opened to unchuck the conveyance article M1, the elastic body 743 expands and recovers the original shape. At that time, the elastic body 743 absorbs heat. The heat flux sensor 10 constantly measures the heat flux from the elastic body 743.

When the elastic body 743 is in the normal state, the heat flux changes with the lapse of time as illustrated in Fig. 41. Specifically, at the time of chucking the conveyance article M1, the heat flux waveform has a positive peak. At the time of unchucking the conveyance article M1, the heat flux waveform has a negative peak.

As with the stopper 64, the elastic body 743 becomes deteriorated and fatigued when being used for a long period of time. This makes the elastic body 743 less able to deform elastically. Accordingly, when the elastic body 743 is in the deteriorated state, the absolute values of peaks of the heat flux waveform at the time of chucking and unchucking are smaller than those in the normal state as illustrated in Fig. 41.

When the deterioration and fatigue of the elastic body 743 proceeds, the elastic body 743 becomes broken and enters the failed state. In the failed state, the peak of the heat flux waveform is hardly seen as illustrated in Fig. 41.

Accordingly, as illustrated in Fig. 41, first thresholds qt11 and qt12 are set to discriminate the normal state from the other states of the elastic body 743, and second thresholds qt13 and qt14 are set to discriminate the deteriorated state from the failed state of the elastic body 743. The second thresholds qt13 and qt14 are set to smaller absolute values than the first thresholds qt11 and qt12.

As in the fifth embodiment, the control device 12 performs the preventive maintenance diagnosis described in the flowchart of Fig. 31, using the detection value qx of the heat flux sensor 10 with the timing of chucking, the first threshold qt11, and the second threshold qt13. In this case, the first threshold qt1 and the second threshold qt2 described in Fig. 31 are respectively replaced with the first threshold qt11 and the second threshold qt13.

As in the fifth embodiment, the control device 12 also performs the preventive maintenance diagnosis described in the flowchart of Fig. 31, using the detection value qx of the heat flux sensor 10 with the timing of unchucking, the first threshold qt12, and the second threshold qt14. In this case, the first threshold qt1 and the second threshold qt2 described in Fig. 31 are replaced respectively with the first threshold qt12 and the second threshold qt14.

This makes it possible to detect whether the elastic body 743 is in the normal state, the deteriorated state, or the failed state. The preventive maintenance diagnosis may be made using the detection value with the timing of either chucking or unchucking.

### (Ninth embodiment)

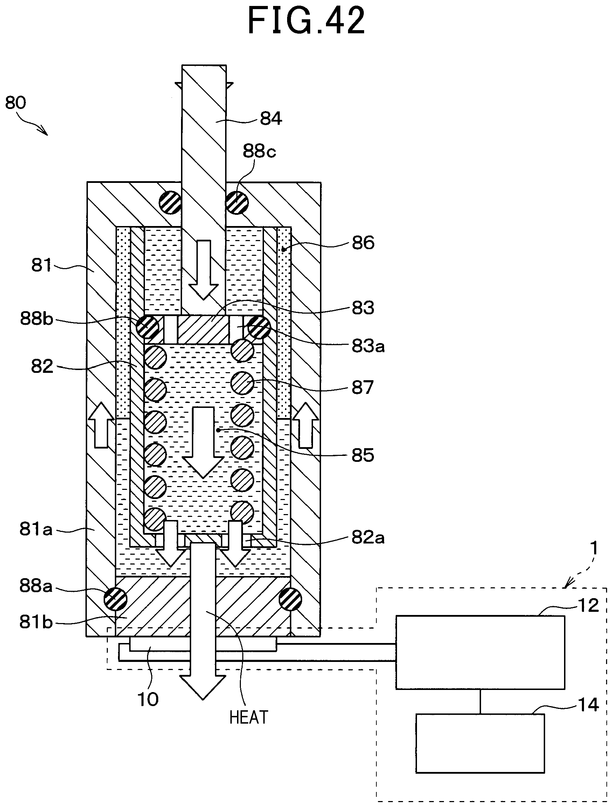

A diagnostic apparatus 1 of a ninth embodiment illustrated in Fig. 42 is designed to perform a preventive maintenance diagnosis of a shock absorber 80 as a measurement target.

The shock absorber 80 is used as a brake of an air cylinder conveying a conveyance article. Specifically, the shock absorber 80 is used as a brake of a drive device that is difficult to control freely acceleration and deceleration.

The shock absorber 80 includes an outer case 81, an inner case 82, a piston 83, a piston rod 84, oil 85, a gas 86, and springs 87.

The inner case 82 is disposed in the outer case 81. The inner case 82 has orifices 82a in the bottom portion. The piston 83 is disposed in the inner case 82. The piston 83 has orifices 83a. The piston rod 84 is connected to the piston 83.

The oil 85 is disposed in the inner case 82. The oil 85 is also interposed between the outer case 81 and the inner case 82. The gas 86 is interposed between the outer case 81 and the inner case 82. The springs 87 are disposed in the inner case 82.

The shock absorber 80 includes rubber seal members 88a that seal between a main body portion 81a and a cap 81b of the outer case 81. The shock absorber 80 also includes rubber seal members 88b that seal between the piston 83 and the inner case 82. The shock absorber 80 further includes rubber seal members 88c that seal between the piston rod 84 and the outer case 81.

In the shock absorber 80, when the piston rod 84 is subjected to shock, the piston 83 is pressed into a bottom portion side of the inner case 82. Accordingly, the oil 85 in the inner case 82 passes through the orifices 82a and 83a. At the time of the oil 85 passing through the orifices 82a and 83a, the fluid friction resistance attenuates the shock. At that time, the fluid friction resistance generates heat. The generated heat flows to the outside air through the outer case 81. In this way, the shock absorber 80 converts the kinetic energy of pressing the piston 83 into heat and radiates heat to absorb the kinetic energy.

In the ninth embodiment, a heat flux sensor 10 is attached to an outer surface of the cap 81b. Alternatively, the heat flux sensor 10 may be attached to an outer surface of the main body portion 81a. The diagnostic apparatus 1 constantly measures the heat flux generated by the shock absorber 80 by the heat flux sensor 10 during the conveyance of a conveyance article.

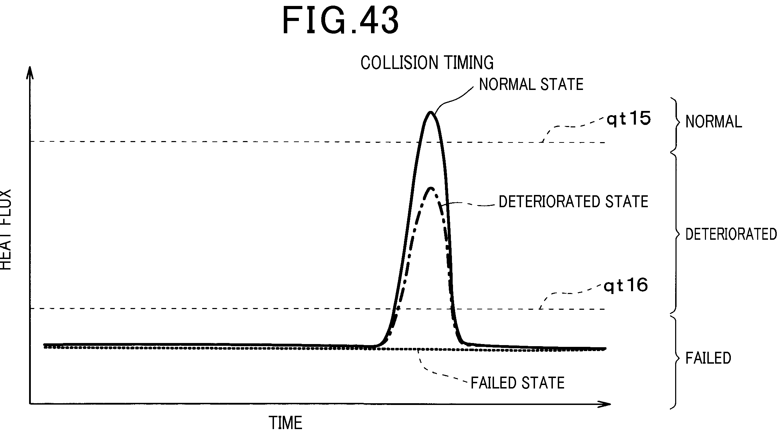

When the seal members 88a, 88b, and 88c of the shock absorber 80 are in the normal state, the heat flux changes with the lapse of time as illustrated in Fig. 43. Specifically, a peak appears in the heat flux change with the lapse of time with the timing when the conveyance article collides with the shock absorber 80.

When the shock absorber 80 is continuously used for a long period of time, there occurs a deterioration phenomenon that the seal members 88a, 88b, and 88c become deteriorated and the oil 85 leaks from the same. In addition, there occurs another deterioration phenomenon that the orifices 82a and 83a become widened due to the fluid friction. When the oil decreases or the orifices 82a and 83a increase in opening area, the conversion of kinetic energy into heat energy becomes reduced. This decreases the kinetic energy that can be absorbed by the shock absorber 80. This makes the brake of the air cylinder less effective. Consequently, such a failure as drop of a conveyance article during conveyance may readily occur due to the shock of an abrupt stop.

In this way, when the shock absorber 80 is in the deteriorated state, the conversion into heat energy decreases. Accordingly, the output from the heat flux sensor 10 changes with the lapse of time as illustrated in Fig. 43. That is, the height of the peak of the heat flux generated by the collision of the conveyance article becomes smaller than that in the normal state.

In addition, when the shock absorber becomes further deteriorated and enters the failed state in which the functionality of the shock absorber is lost, the peak of the heat flux waveform is hardly seen as illustrated in Fig. 43.

Accordingly, as illustrated in Fig. 43, a first threshold qt15 is set to discriminate the normal state from the other states of the shock absorber 80, and a second threshold qt16 is set to discriminate the deteriorated state from the failed state of the shock absorber 80. The second threshold qt16 is set to a smaller value than the first threshold qt15.

As in the fifth embodiment, the control device 12 performs the preventive maintenance diagnosis described in the flowchart of Fig. 31, using the detection value qx of the heat flux sensor 10, the first threshold qt15, and the second threshold qt16. As the detection value qx, the detection value qx at the time of the collision of the conveyance article. As the detection value qx, the maximum value of the detection value qx may be used. In the ninth embodiment, the first threshold qt1 and the second threshold qt2 illustrated in Fig. 31 are respectively replaced with the first threshold qt15 and the second threshold qt16. This makes it possible to detect that the shock absorber 80 is in the normal state, the deteriorated state, or the failed state.

### (Other embodiments)

The present invention is not limited to the foregoing embodiments but can be modified as appropriate within the scope of the claims as described below.
(1) In each of the foregoing embodiments, the heat flux sensor 10 detects the heat flux continuously from the start of operation of the measurement target. Alternatively, the heat flux sensor 10 may detect the heat flux at predetermined time intervals. The time intervals are preferably as short as possible.
(2) The diagnostic apparatus 1 of the first embodiment detects the heat flux generated by current and voltage. The diagnostic apparatus 1 of the second embodiment detects the heat flux generated by friction. The diagnostic apparatus 1 of the third embodiment detects the heat flux generated by sound. The diagnostic apparatus 1 of the fourth embodiment detects the heat flux generated by vibration and friction. The kind of flux detected by the measurement target may be any of current, voltage, sound, vibration, and friction. The heat flux detected by the measurement target may be of one or more kinds. That is, the heat flux detected by the measurement target may be heat flux generated by at least one of current, voltage, sound, vibration, and friction. In addition, the heat flux detected by the measurement target may be heat flux generated by current, voltage, sound, vibration, friction, deformation of an object, or pressure.
   For example, when a production facility becomes deteriorated, at least one of vibration, friction, sound, voltage, and current changes as compared to that in the normal state to change the heat flux generated from the production facility. In addition, when the production facility becomes deteriorated, vibration, friction, sound, voltage, electric current, degree of deformation of an object, and pressure change as compared to those in the normal state to change the heat flux generated from the production facility. Accordingly, an abnormality is detected based on the change in the heat flux. When the abnormality is detected, the production facility undergoes maintenance. This makes it possible to prevent the occurrence of failed products due to the deterioration of the production facility.
   In addition, when various components mounted in an automobile become deteriorated, at least one of vibration, friction, sound, voltage, and current varies and changes the heat fluxes generated by the various components. Accordingly, an abnormality is detected based on the changes in the heat fluxes. When the abnormality is detected, the production facility undergoes maintenance. This eliminates the need for replacement of the components allowing for safety at inspections of the automobile, and allows the driver to run continuously without concern about the failure of the components.
(3) In the diagnostic apparatus 1 of each of the foregoing embodiments, even when an abnormality appears at a place different from one that is to be inspected, the heat flux is changed by the abnormality. Accordingly, detecting the heat flux from the measurement target by the heat flux sensor 10 and determining whether there is an abnormality based on the result of the detection make it possible to learn the presence or absence of an abnormality.
(4) In each of the foregoing embodiments, the display device 14 is used as an announcement device. Alternatively, a sound issuing device such as a buzzer may be used.
(5) The foregoing embodiments are not unrelated to each other but can be combined as appropriate unless the combination is clearly impossible. In addition, in the foregoing embodiments, it is obvious that the constituent elements of the embodiments are not necessarily essential unless it is explicitly specified that they are essential in particular or it is clearly considered that they are essential in principle.

### [Reference Signs List]

1 ... Abnormality diagnosis device
2 ... Battery
5 ... Automatic door device
10 ... Heat flux sensor
12 ... Control device
31 ... Drill
41 ... Filter

## Claims

1. An abnormality diagnostic apparatus that determines the presence or absence of an abnormality that appears before occurrence of a failure in a measurement target (2, 31, 41, 5, 61, 64, 743, 241, 227, 80), comprising:
a heat flux sensor (10) that detects heat flux generated by the measurement target continuously from the start of operation of the measurement target or at predetermined time intervals; and
a determination unit (12) that determines whether there is the abnormality based on the result of the detection by the heat flux sensor.

2. The abnormality diagnostic apparatus according to claim 1, wherein the heat flux detected by the measurement target is heat flux generated by at least one of current, voltage, sound, vibration, and friction.

3. The abnormality diagnostic apparatus according to claim 1, wherein the heat flux detected by the measurement target is heat flux generated by at least one of current, voltage, sound, vibration, friction, deformation of an object, and pressure.

4. The abnormality diagnostic apparatus according to any one of claims 1 to 3, wherein the determination unit compares a detection value of the heat flux sensor with a predetermined first reference range and a second reference range that includes the first reference range and is made wider than the first reference range, and when the detection value falls outside the first reference range and falls within the second reference range, the determination unit determines that there is the abnormality.
